(19) Europäisches Patentamt / European Patent Office / Office européen des brevets

(11) **EP 1 176 630 B1**

(12) **EUROPEAN PATENT SPECIFICATION**

(45) Date of publication and mention of the grant of the patent:
**27.06.2007 Bulletin 2007/26**

(51) Int Cl.:
***H01L 21/304*** (2006.01)          ***B24B 37/04*** (2006.01)

(21) Application number: **00908067.2**

(22) Date of filing: **14.03.2000**

(86) International application number:
**PCT/JP2000/001545**

(87) International publication number:
**WO 2000/060650 (12.10.2000 Gazette 2000/41)**

(54) **POLISHING BODY, POLISHER, METHOD FOR ADJUSTING POLISHER, METHOD FOR MEASURING THICKNESS OF POLISHED FILM OR END POINT OF POLISHING, METHOD FOR PRODUCING SEMICONDUCTOR DEVICE**

POLIERKÖRPER, POLIERMASCHINE, POLIERMASCHINENJUSTIERVERFAHREN, DICKEN- ODER ENDPUNKT-MESSVERFAHREN FÜR DIE POLIERTE SCHICHT, HERSTELLUNGSVERFAHREN EINES HALBLEITERBAUELEMENTES

CORPS DE POLISSAGE, DISPOSITIF DE POLISSAGE, PROCEDE DE REGLAGE DU DISPOSITIF DE POLISSAGE, DISPOSITIF DE MESURE DE L'EPAISSEUR DU FILM POLI OU DU POINT TERMINAL DE POLISSAGE, PROCEDE DE FABRICATION D'UN DISPOSITIF A SEMI-CONDUCTEUR

(84) Designated Contracting States:
**DE FR GB**

(30) Priority: **31.03.1999 JP 9107799**
**03.12.1999 JP 34505899**
**20.01.2000 JP 2000011126**
**02.02.2000 JP 2000025323**

(43) Date of publication of application:
**30.01.2002 Bulletin 2002/05**

(73) Proprietor: **NIKON CORPORATION**
**Tokyo 100-0005 (JP)**

(72) Inventors:
 • **Ishikawa, Akira,**
 **Nikon Corporation**
 **Tokyo,**
 **Tokyo 100-1005 (JP)**
 • **Senga, Tatsuya,**
 **Nikon Corporation**
 **Tokyo,**
 **Tokyo 100-1005 (JP)**
 • **Miyaji, Akira,**
 **Nikon Corporation**
 **Tokyo,**
 **Tokyo 100-1005 (JP)**
 • **Ushio, Yoshijiro,**
 **Nikon Corporation**
 **Tokyo,**
 **Tokyo 100-1005 (JP)**

(74) Representative: **Viering, Hans-Martin**
**Viering, Jentschura & Partner**
**Patent- und Rechtsanwälte**
**Postfach 22 14 43**
**80504 München (DE)**

(56) References cited:
**EP-A- 0 941 806**          **EP-A1- 0 738 561**
**JP-A- 10 125 634**          **JP-A- 11 014 305**
**US-A- 5 433 651**          **US-A- 5 605 760**

 • **PATENT ABSTRACTS OF JAPAN vol. 1995, no. 05, 30 June 1995 (1995-06-30) -& JP 07 052032 A (SUMITOMO METAL MINING CO LTD), 28 February 1995 (1995-02-28)**

## Description

Background Technology

The present invention relates to a polishing body as per the preamble of claim 1 and claim 5. An example of such a polishing body is disclosed by US-A-5 433 651.

As semiconductor integrated circuits have become finer and more highly integrated, the individual processes involved in semiconductor manufacturing process es have become more numerous and complicated. As a result, the surfaces of semiconductor devices are not always flat. The presence of step differences on the surfaces of semiconductor devices leads to step breakage of wiring and local increases in resistance, etc., and thus causes wiring interruptions and drops in electrical capacitance. In insulating films, furthermore, [such step differences] also lead to a deterioration in the withstand voltage and the occurrence of leaks.

Meanwhile, as semiconductor integrated circuits have become finer and more highly integrated, the wavelengths of light sources in semiconductor exposure apparatuses used in photolithography have become shorter, and the numerical aperture or so -called NA of the projection lenses used in such semiconductor exposure apparatuses has become larger. As a result, the focal depth of the projection lenses used in such semiconductor exposure apparatuses has become substantially shallower. In order to deal with such increasing shallowness of the focal depth, there is a demand for even greater planarization of the surfaces of semiconductor devices than that achieved so far.

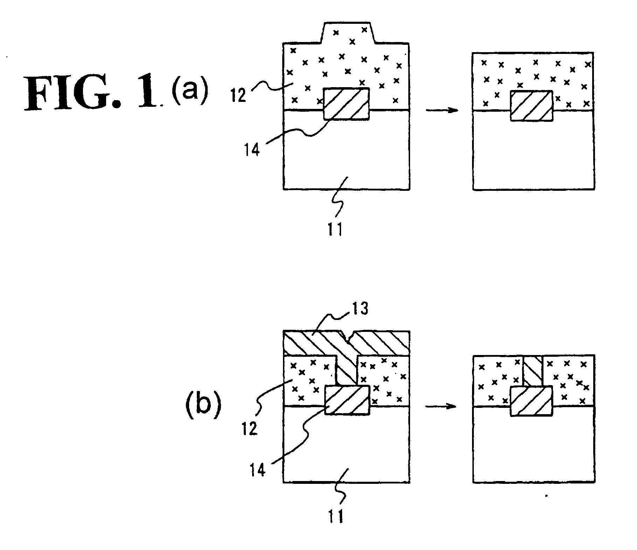

To describe this in concrete terms, planarization techniques such as that shown in Figure 1 have become essential in semiconductor [manufacturing] processes. A semiconductor device 14, and inter-layer insulating film 12 consisting of $SiO_2$ and a metal film 13 consisting of A1 are formed on the surface of a silicon wafer 11. Figure 1 (a) shows an example of the planarization of an inter-layer insulating film 12 on the surface of the semiconductor device. Figure 1 (b) shows an example in which a so-called damascene is formed by polishing a metal film 13 on the surface of the semiconductor device.

A chemical mechanical polishing or chemical mechanical plarization (hereafter referred to as "CMP") technique is widely used as a method for planarizing the surfaces of such semiconductor devices. Currently, the CMP technique is the sole method that can be used to planarize the entire surface of a silicon wafer.

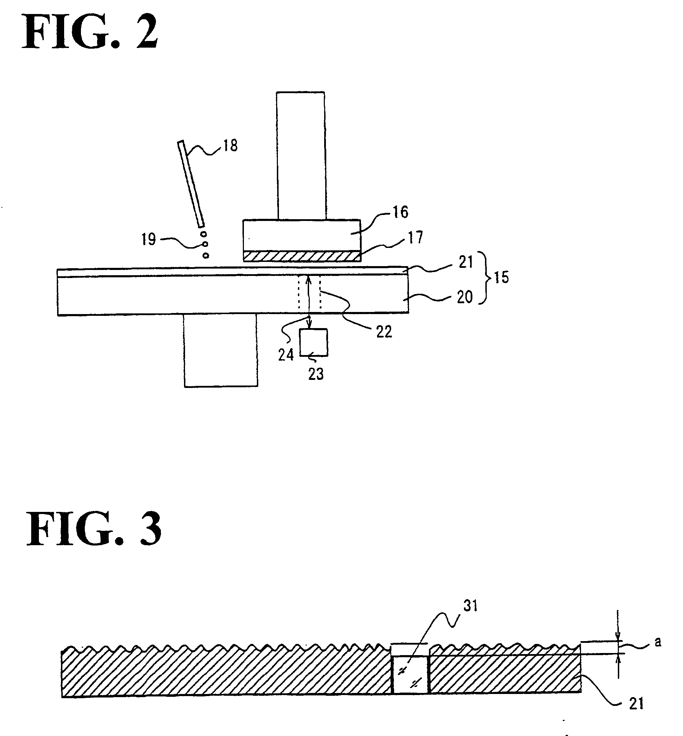

CMP was developed on the basis of silicon wafer mirror surface polishing methods. Figure 2 is a schematic structural diagram of a polishing (planarization) apparatus used in CMP. This polishing apparatus is constructed from a polishing member 15, an object of polishing holding part (hereafter referred to as a "polishing head" in some instances) 16, and a polishing agent supply part 18. Furthermore, a silicon wafer 17 which is the object of polishing is attached to the polishing head 16, and the polishing agent supply part 18 supplies a polishing agent (slurry) 19. The polishing member 15 is formed by attaching a polishing body (hereafter referred to as a "polishing pad" in some instances) 21 to the surface of a platen 20.

The silicon wafer 17 is held by the polishing head 16, so that it is caused to oscillate while being rotated, and is pressed against the polishing body 21 of the polishing member 15 with a specified pressure. The polishing member 15 is also rotated, so that a relative motion is performed between [the polishing member 15 and] the silicon wafer 17. In this state, the polishing agent 19 is supplied to the surface of the polishing body 21 from the polishing agent supply part 18. The polishing agent 19 diffuses over the surface of the polishing body 21, and enters the space between the polishing body 21 and the silicon wafer 17 as the polishing member 15 and silicon wafer 17 move relative to each other, so that the polishing surface of the silicon wafer 17 is polished. Specifically, good polishing is accomplished by a synergistic effect of the mechanical polishing caused by the relative motion of the polishing member 15 and silicon wafer 17 and the chemical action of the polishing agent 19.

The relationship between the amount of polishing of a silicon wafer and the above-mentioned polishing conditions is given by an empirical formula known as the formula of Preston, which is indicated by Equation (1).

$$R = k \times P \times V \qquad \ldots (1)$$

Here, R is the amount of polishing of the silicon wafer, P is the pressure per unit area with which the silicon wafer is pressed against the polishing body, V is the relative linear velocity caused by the relative motion between the polishing member and the silicon wafer, and k is a proportionality constant.

Conventionally, the endpoint of CMP polishing has been determined by time control using the formula of Preston on the basis of the polishing rate calculated by means of film thickness measurement using an ellipsometer, etc., after polishing several tens of dummy samples and performing a cleaning process. In CMP, however, variation occurs in the polishing rate because of the temperature distribution of the polishing body and local differences in the polishing agent supply conditions. Furthermore, because of variations in the surface conditions of the polishing body, the polishing rate drops with the number of wafers processed, and there are differences in the polishing rate due to individual differences between polishing bodies, etc. Accordingly, it is difficult to determine the endpoint [of polishing] by performing a specified amount of polishing using time control.

Furthermore, the time control method requires polishing work using as many as several tens of dummy samples in order to determine the polishing rate. Accordingly, this polishing work results in increased costs, and is therefore undesirable for stabilizing the semiconductor device manufacturing process and reducing production costs.

For such reasons, methods in which the endpoint [of polishing] is determined while measuring the motor torque or vibration, etc., in situ have been proposed as a substitute for endpoint determination by time control. Such methods are effective to some extent in the case of CMP in which the material that is the object of polishing varies (e.g., CMP of wiring materials or CMP in which there are stopper layers). However, in the case of silicon wafers that have complicated patterns, there is little variation in the material that is the obj ect of polishing; accordingly, there are cases in which it is difficult to ascertain the endpoint. Furthermore, in the case of CMP of inter-layer insulating films, it is necessary to control the inter-wiring capacitance; accordingly, control of the residual film thickness is required rather than control of the polishing endpoint. It is difficult to measure the film thickness using a method in which the endpoint is ascertained by in-situ measurement of the motor torque or vibration, etc.

Recently, optical measurements, especially in-situ endpoint detection and in -situ film thickness measurement based on the measurement of spectroscopic reflections, have come to be viewed as effective means of solving the above-mentioned problems. For instance, one example of such measurement is described in USP 5,433,651. In regard to the construction used for such in-situ measurements, a common method is a method in which an opening part 22 used for measurement is formed in the platen 20 and polishing body 21 a shown in Figure 2, and the surface of the object of polishing is observed by means of a polished-state measuring device 23 that measures the polished state via this opening part 22. Although this is not shown in Figure 2, a transparent window is generally installed in the polishing body 21, etc., in order to close off the opening part. By installing such a window, it is possible to allow the measurement light from the polished-state measuring device 33 to pass through the window, while preventing the polishing agent 19 from leaking into the polished-state measuring device 23 via the opening part 22. In cases where no window is installed, the slurry and water used in cleaning, etc., leak from this area; as a result, a complicated climate is required, so that the apparatus becomes complicated.

A so-called foam polishing pad consisting of a foam polyurethane has been used in the past as the polishing body 21. However, in the case of foam polyurethane polishing pads, the polishing agent causes clogging, so that the polishing characteristics are unstable. Accordingly, in the case of foam polyurethane polishing pads, dressing of the polishing pad surface is generally performed by means of a diamond grinding wheel in order to perform stable polishing. Dressing is a treatment which removes the polishing agent that has clogged [the surface of the polishing pad], and which at the same time cuts away the surface of the foam polyurethane polishing pad, so that a fresh polishing pad surface is created. Recently, furthermore, non-foam polishing bodies that do not require dressing have also begun to be used.

In cases where a window used for measurement is formed in the polishing pad for the purpose of performing the above-mentioned optical measurements, because the polis hing body is generally not transparent, it is necessary to install a transparent material that differs from the material of the polishing body in the area where the window is formed. Since this material generally differs from the material of the polishing body in terms of mechanical properties, there is a serious danger that this material will cause differences in the polishing rate, non-uniformity of polishing, and scratching. Furthermore, the following problem also arises: since the window is scratched so that it becomes optically opaque at the same time that the polishing body (polishing pad) is cut away during the above-mentioned dressing, in-situ measurement becomes impossible.

Furthermore, since the polishing agent is discharged onto the polishing body during polishing, observation must be performed through the polishing agent as well. Since the polishing agent, which is a dispersion, causes attenuation of the measurement light, it is better if the amount of polishing agent that is interposed in the measurement light path when high-precision measurements are being performed is small. Specifically, if there is a step difference between the surface of the polishing body and the surface of the window on the side of the object of polishing, the polishing agent will accumulate in the opening part and cause attenuation of the measurement light; accordingly, it is better if there is no such step difference.

Furthermore, in order to reduce the loss of the intensity of the light that is used to measure the polished state, it is desirable to form an anti reflection film on the opposite surface of the window from the side of the silicon wafer. However, in cases where an anti-reflection film is formed on a window that is manufactured from a soft material, cracks are formed in the anti-reflection film as a result of the bending of the window; furthermore, since the glass transition temperature of the window is low, the window may expand or contract as a result of temperature changes, so that cracks are formed in the anti-reflection film. Accordingly, in cases where the window is manufactured from a soft material, the problem is that the formation of an anti-reflection film is difficult

Furthermore, in cases where a soft transparent material that does not cause scratching of the silicon wafer, e.g., a polyurethane, nylon or soft acrylic [resin], etc., is disposed in the opening part, the pressure that is applied to the window fluctuates when the opening part moves beneath the silicon wafer as a result of the rotation of the platen, so that the window that is installed undergoes deformation, thus causing optical distortion. As a result of this distortion, the window acts as a lens, etc.,

so that there is a problem in that detection of the polishing endpoint and measurement of the film thickness become unstable.

Furthermore, the problem of erroneous measurement arises in cases where the polished film thickness or polishing endpoint is measured without a constant thickness of the polishing agent between the window and the object of polishing.

Disclosure of the Invention

The object of the present invention is to solve the above-mentioned problems, and to provide a polishing body according to claim 1 or 5, a polishing apparatus according to claim 11 and a method for measuring the thickness of a polished film or the endpoint of polishing according to claim 14.

Brief Description of the Drawings

Figure 1 shows an example of a planarization technique used in a semiconductor process; the left side of the figures shows the state prior to planarization, while the right side of the figures shows the state following planarization.

Figure 2 is a schematic structural diagram of a polishing (planarization) apparatus used in CMP.

Figure 3 is a diagram which is used to illustrate a first example of a polishing pad (polishing body) that constitutes a working configuration of the present invention.

Figure 4 is a diagram which is used to illustrate a second example of a polishing pad (polishing body) that constitutes a working configuration of the present invention.

Figure 5 is a diagram which is used to illustrate a third example of a polishing pad (polishing body) that constitutes a working configuration of the present invention.

Figure 6 is a diagram which is used to illustrate a fourth example of a polishing pad (polishing body) that constitutes a working configuration of the present invention.

Figure 7 is a diagram which is used to illustrate a fifth example of a polishing pad (polishing body) that constitutes a working configuration of the present invention.

Figure 8 is a diagram which is used to illustrate a sixth example of a polishing pad (polishing body) that constitutes a working configuration of the present invention.

Figure 9 is a diagram which is used to illustrate a first example of a polishing pad (polishing body) that constitutes an embodiment of the present invention.

Figure 10 is a diagram which illustrates the shape of the V-shaped groove of the polishing pad shown in Figure 9.

Figure 11 is a graph which shows an example of the variation in the residual film thickness observed during polishing.

Figure 12 is a graph which shows reflective spectra from the silicon wafer surface measured in situ at certain instants during polishing.

Figure 13 is a diagram which shows the structure of an embodiment of the polishing body [of the present invention] which has window plates consisting of a two-layer structure.

Figure 14 is a graph which shows a reflective spectrum from the silicon wafer surface measured in situ.

Figure 15 is a diagram which shows examples of the processes used to manufacture the polishing body [of the present invention].

Figure 16 shows an example of a graph which shows a reflective spectrum observed during polishing.

Figure 17 is a sectional view of the area in the vicinity of [one of] the opening parts in the platen of a polishing apparatus which constitutes a working configuration of the present invention.

Figure 18 is a diagram showing an outline of the area in the vicinity of the polishing body of a polishing apparatus constructed according to this working configuration.

Figure 19 is a graph which shows reflective spectra from the silicon wafer surface measured in situ at certain instants during polishing.

Figure 20 is a flow chart which illustrates the semiconductor device manufacturing process.

Preferred Working Configurations of the Invention

Below, [working configurations] will be described with reference to the attached figures in order to describe the present invention in greater detail. However, the present invention is described [here] in terms of working configurations and embodiments, and this description should not be interpreted as limiting the content of the invention.

First, examples of working configurations and embodiments of the invention for the purpose of achieving the first object of the present invention will be described.

[Working Configuration 1-1]

Figure 3 is a diagram which is used to illustrate a first example of a polishing pad (polishing body) constituting a working configuration of the present invention. In the following figures, constituent elements that are the same as constituent elements shown in pr eceding figures are labeled with the same symbols, and a description of such constituent elements may be omitted. In Figure 3, 21 indicates a polishing pad, and 31 indicates a transparent window plate.

The transparent window plate 31 is fit into a hole that is bored in the polishing pad 21. Here, a gap $\alpha$ is left between the upper surface of the transparent window plate 31 and the outermost surface that constitutes the working surface of the polishing pad 21. During polishing, a polishing head 16 which holds the wafer 17 as shown in Figure 2 is caused to apply a load to the polishing pad by means of a load-applying mechanism (not shown in the figures), so that the polishing pad 21 and transparent window plate 31 are compressed. In this case, it is desirable that the gap *a* be as constant as possible, and that a dimension that is equal to or greater than a standard value be maintained.

A soft polishing pad made of a foam urethane is not very desirable as [the above-mentioned] polishing pad. The reason for this is as follows: widely used soft polishing pads made of a foam urethane generally show a large amount of compressive deformation of the polishing pad due to the load applied during polishing. Accordingly, not only is it necessary to set the gap *a* that exists in an unloaded/non-compressed state at a large value, but the amount of flexing that occurs in response to dynamic forces such as irregular vibration of the wafer or retainer ring of the polishing head, etc., during loading/polishing is large, so that it is also necessary to prevent scratching that might be caused by the polished surface of the wafer or the retainer ring of the polishing head contacting the upper surface of the window plate when maximum flexing occurs. Consequently, the gap *a* that exists during the loading/compression of polishing must be set at a relatively large value, and the slurry enters the space created by this gap *a* on the surface of the transparent window plate 31, so that the measurement light must pass through this slurry. Consequently, the rate of transmission of the measurement light drops.

From the above standpoint, it is desirable to use a hard polishing pad in which the amount of compressive deformation is small as the polishing pad. The reason for this is as follows: [in such a case,] since the amount of compressive deformation is small for the polishing load, the gap *a* that exists in an unloaded/non-compressed state can be kept at a small value; furthermore, since the amount of flexing that occurs in response to dynamic forces such as irregular vibration of the wafer or retainer ring of the polishing head during polishing is small even when the polishing load is applied, the gap $\alpha$ that exists in the loaded/compressed state can be kept to a small value. If the gap *a* that exists in the loaded/compressed state can be reduced, the transmissivity with respect to the measurement light is increased, which is desirable for high-precision and stable measurement of the polished state.

The thickness of the window plate must be varied in accordance with the thickness of the polishing pad. The transmissivity of the window plate 31 with respect to the measurement light and the slurry present in the recessed part on the surface of the window plate 31 depends on the gap *a* that exists in the loaded/compressed state, the concentration of the slurry and the thickness and material of the window plate.

In order to achieve high-precision and stable measurement of the polished state, it is desirable that the transmissivity of the window plate 31 be 22% or greater. It is desirable that the [combined] transmissivity of both the window plate 31 and the slurry present in the recessed part on the window plate with respect to the measurement light be 10% or greater (1% or greater in terms of round-trip transmissivity) in the loaded/compressed state. However, in cases where the intensity of the light source is strong, or in cases where the sensitivity of the sensor is high, measurement is possible even if this transmissivity is less than 10%.

If a transparent material is selected as the window plate material, then the above-mentioned transmissivity with respect to the measurement light depends substantially on the concentration of the slurry that enters the recessed part formed above the window plate 31 and the thickness of the slurry layer in the loaded/compressed state.

The permissible value of the gap *a* depends on the slurry concentration; however, in the case of a common slurry concentration, it is desirable that this gap be 0 to 400 $\mu$m. The reason that this gap is set at a value greater than zero is to prevent the window plate 31 from contacting the object of polishing or the diamond grinding wheel during dressing. The reason that this gap is set at 400 $\mu$m or less is to avoid attenuation of the measurement light by the slurry. Furthermore, for the same reasons, it is even more desirable that the gap *a* be set at 10 to 200 $\mu$m. The value of this gap *a* is generally large in the case of a soft polishing pad made of a foam urethane, and small in the case of a non-foam hard polishing pad.

Furthermore, in spite of the fact that the above-mentioned gap *a* is determined with the load during polishing taken into account so that [the window plate] does not contact the wafer or the retainer ring of the polishing head, the window plate may on rare occasions make unexpected contact with the wafer or retainer ring of the polishing head due to irregular vibrations during polishing, so that scratching occurs. Accordingly, in order to prevent this, it is desirable that at least the surface of the window plate that is located on the wafer side be coated with a hard coating. For example, in the case of an acrylic resin, a method in which a hard coating is applied by means of a silicon[e] type organic resin is desirable.

The polishing pad described above is desirable for use in cases where the material of the polishing pad itself is opaque to the measurement light. It goes without saying that such measurement window parts are unnecessary in the case of a polishing pad in which the material of the polishing pad is transparent to the measurement light.

In the case of the polishing pad of the present working configuration, a polishing pad of the configuration shown in Figure 3 may be fastened to the platen 20 of the polishing apparatus shown in Figure 2 and used "as is", or may be used after being fastened to the platen 20 in a form in which [the polishing pad] is caused to flow into the platen (consisting of an aluminum plate, etc.). Alternatively, [a polishing pad] backed by one or more layers of other appropriate different materials may be fastened to the platen 20 and used.

Thus, in the polishing apparatus shown in Figure 2, the state of polishing can be favorably measured by the [above-mentioned] polished-state measuring device 23 during polishing, as a result of the above-mentioned desirable function of the polishing pad 21 fastened to the platen 20.

Furthermore, in regard to the relationship between the intensity of the measurement li ght 24 that is emitted from the polished -state measuring device 23 and the intensity of the light that passes through the window plate 31, passes through the polishing agent in the recessed part formed on the window plate 31, is reflected by the polished surface of the object of polishing 17, again passes through the polishing agent in the above-mentioned recessed part and the window plate 31 and returns to the polished-state measuring device 23, it is desirable that the ratio of the intensity of the light that returns to the polished-state measuring device 23 to the intensity of the measurement light 24 emitted from the polished-state measuring device 23 be 1% or greater, and a ratio of 5% or greater is even more desirable. In this way, the intensity of the light that returns to the polished-state measuring device 23 does not drop, so that high-precision and stable measurement of the polished state can be accomplished by means of the polished-state measuring device 23.

[Working Configuration 1-2]

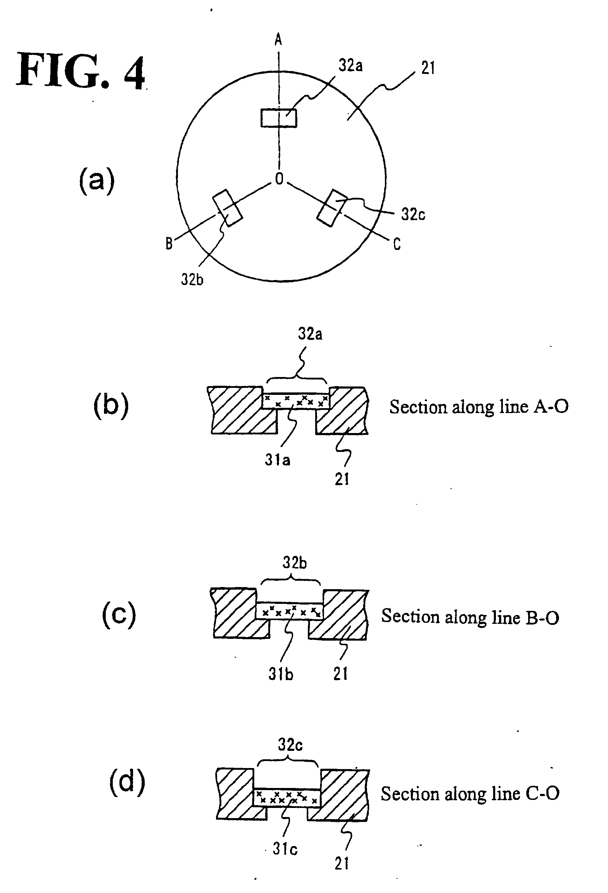

Figure 4 is a diagram which is used to illustrate a second example of a polishing pad (polishing body) that constitutes a working configuration of the present invention. Figure 4 (a) is a plan view, Figure 4 (b) is a sectional view of the portion indicated by line A-O in Figure 4 (a), Figure 4 (c) is a sectional view of the portion indicated by line B-O in Figure 4 (a), and Figure 4 (d) is a sectional view of the portion indicated by line C-O in Figure 4 (a). In Figure 4, 31a through 31c indicate window plates, and 32a through 32c indicate opening parts.

In the present working configuration, the polishing body 21 has three opening parts 32a, 32b and 32c. Furthermore, a window plate 31a is disposed in the opening part 32a, a window plate 31b is disposed in the opening part 32b, and a window part 31c is disposed in the opening part 32c. In Figures 1 (b), (c) and (d), the surface on the upper side of the polishing body 21 is the [top] surface of the polishing body 21, and the surfaces on the upper sides of the window plates 31a through 31c are the surfaces of the window plates that are located on the side of the object of polishing.

The surfaces of the respective window plates 31a through 31c are recessed with respect to the surface of the polishing body 21, and the respective amounts of recess are different in each of the opening parts 32a through 32c. As a result, the amount of recess for each of the opening parts 32a through 32c varies in a stepwise manner. In the polishing body 21 of the present working configuration, the amounts of recess of the surfaces of the window plates 31a through 31c on the side of the object of polishing with respect to the surface of the polishing body 21 [are set so that] the amount of recess is smallest in the case of the window plate 31 a of the opening part 32a, and largest in the case of the window plate 31c of the opening part 32c. The amount of recess of the window plate 31b of the opening part 32b is more or less intermediate between the amount of recess of the opening part 31a and the amount of recess of the opening part 32c.

Such a polishing body 21 is attached to the polishing apparatus shown in Figure 2 and used. The polishing body 21 is bonded to the platen 20 by means of a two -sided tape or an adhesive agent. Furthermore, the window bodies and opening parts disposed in the polishing body 21 are omitted from Figure 2. The opening part 22 formed in the platen 20 and the opening parts 32a through 32c formed in the polishing body 21 are superimposed.

In the initial state immediately following the initiation of polishing, the area of the opening part 32a, in which the amount of recess of the surface of the window on the side of the object of polishing with respect to the surface of the polishing body is smallest, is use d to observe the state of the polished surface. In this way, the state of the polished surface is observed by means of the light that passes through the window plate 31a installed in the opening part 32a (among the light that returns to the polished-state measuring device 23 after being emitted from the polished-state measuring device 23 and reflected by the silicon wafer (object of polishing) 17).

A position detection sensor (not shown in the figures) is installed on the platen 20. When the platen 20 rotates so that a specified position on the platen 20 reaches the position of the position detection sensor, the position detection sensor outputs a trigger signal. The time interval required for the platen 20 to rotate from the position of the platen 20 at which the position detection sensor outputs a trigger signal to the position at which the opening part 32a reaches a point above the polished-state measuring device 23 is determined by the rpm of the platen 20.

Accordingly, the above-mentioned time interval can be calculated or measured beforehand, and the polished-state measuring device 23 can be actuated after this time interval has elapsed following the output of the trigger signal by the position detection sensor. As a result, it is always possible to detect the polishing endpoint or measure the film thickness at the opening part 32a.

Each time the polishing of one silicon wafer is completed, the polishing body is dressed. A diamond grinding wheel, etc., is used for this dressing. After dressing is performed, the next silicon wafer that is to be polished is attached to the polishing head 16, and polishing is performed. Thus, the polishing and dressing processes are alternately repeated.

Each time dressing is performed, the surface of the polishing body 21 is ground away, so that the amount of recess above the window plate 31a in the opening part 32a with respect to the surface of the polishing body 21 becomes progressively smaller. When the amount of recess reaches zero, scratching of the surface of the window plate 31a on the side of the object of polishing begins to be caused by dressing. Furthermore, when such scratching of the window occurs, the scattering, etc., of light in the area of the window increases, so that the precision of polishing endpoint detection and the precision of film thickness measurement drop.

Accordingly, a switch is made so that polishing endpoint detection or film thickness measurement is accomplished using the opening part 32b, which has the second smallest amount of recess in the initial state. Such a switch so that polishing endpoint detection or film thickness measurement is performed using the opening part 32b can be accomplished by changing the time interval from the output of the trigger signal by the position detection sensor installed on the platen 20 to the actuation of the polished-state measuring device 23 to the appropriate time interval, and actuating the polished-state measuring device 23 when the opening part 32b arrives at a point above the polished-state measuring device 23.

Then, the polishing process and dressing process are repeated, and when the amount of recess of the surface of the window plate 31b on the side of the object of polishing in the opening part 32b also reaches zero, so that scratching of the surface of the window [plate] 31b on the side of the object of polishing begins to be caused by dressing, another switch is made so that polishing endpoint detection or film thickness measurement is accomplished using the opening part 32c, which has the largest amount of recess of the window in the initial state. The switching of polishing endpoint detection or film thickness measurement from the opening part 32b to [the opening part] 32c can be accomplished in the same manner as the above-mentioned switch from the opening part 32a to [the opening part] 32b. Thus, since the surfaces (on the side of the object of polishing) of the windows installed in the opening parts that are used for polishing endpoint detection and film thickness measurement are recessed with respect to the surface of the polishing body during dressing, there is no scratching of the windows during dressing.

Furthermore, it would also be possible to perform the switching of the opening parts by installing a control device that switches to the next opening part when the amount of light received by the polished-state measuring device 23 drops below a predetermined set value.

Furthermore, in the present working configuration, the platen 20 has three opening parts, and the polishing body 21 has three opening parts in which windows are installed. However, the [respective] numbers of these opening parts may be two opening parts, or four or more opening parts. In such cases, the observation of the polished state can be switched a number of times corresponding to the number of opening parts.

In the polishing apparatus in which the polishing body of the present working configuration is installed, a plurality of windows with different amounts of recess for each opening part are disposed in the polishing body 21; accordingly, even if a [certain] window should be scratched by dressing so that this window becomes optically opaque, polishing endpoint detection or film thickness measurement can be accomplished by switching the window used for polishing endpoint detection or film thickness measurement to the window of another opening part. As a result, the same polishing body can be used in polishing for a longer period of time than is possible in the case of a conventional [polishing body], so that the frequency of replacement of the polishing body or windows is reduced, thus making it possible to reduce the cost of polishing.

[Working Configuration 1-3]

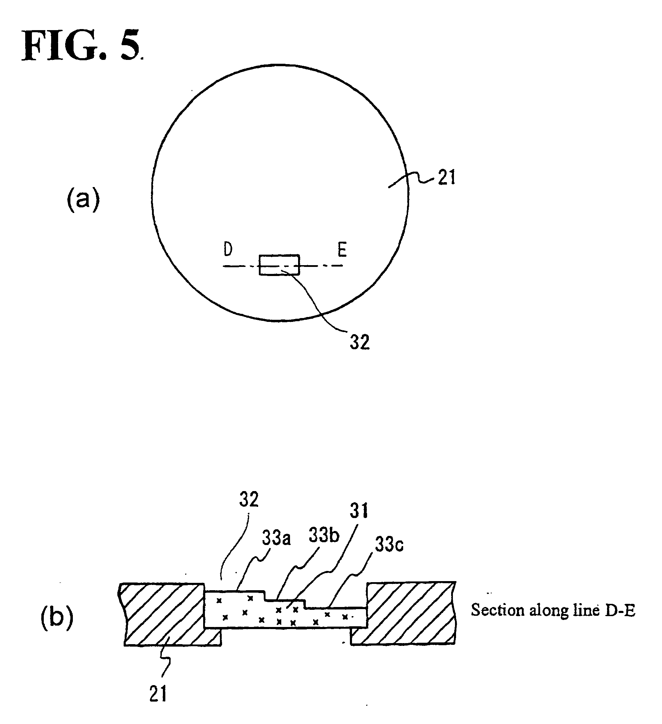

Figure 5 is a diagram which is used to illustrate a third example of a polishing pad (polishing body) that constitutes a working configuration of the present invention. Figure 5 (a) is a plan view, and Figure 5 (b) is a sectional view of the portion indicated by line D-E in Figure 5 (a). In Figure 5, 32 indicates an opening part, and 33a through 33b indicate respective parts of a window plate 31.

The polishing body 21 of the present working configuration has a single opening part 32. The window plate 31 disposed in this opening part 32 has a step -form cross section, so that the amount of recess of the surface of the window plate 31 on the side of the object of polishing with respect to the surface of the polishing body 21 differs in the three parts 33a, 33b and 33c. The amount of recess of the surface of the window plate 31 on the side of the object of polishing with respect to the surface of the polishing body 21 is smallest in the part 33a, and largest in the part 33c. In the part 33b, this amount of recess is more or less intermediate between that in the part 33a and that in the part 33c. As a result, the amount of recess of the surface of the window plate 31 on the side of the object of polishing varies in a stepwise manner.

In cases where a polymer resin is used as the material of the window plate 31, a window plate 31 which has a step-form difference in the surface can be manufactured by causing the resin to flow in a liquid state into a mold that has step differences, and then curing the resin.

Such a polishing body is attached to the polishing apparatus shown in Figure 2 and used. In this case, an opening part 22 formed in the platen 20 is arranged so that it is superimposed on the opening part 32 formed in the polishing body 21.

In the initial state immediately following the initiation of polishing, the part 33a, in which the amount of recess of the surface of the window plate 31 on the side of the object of polishing with respect to the surface of the polishing body is smallest, is used for the observation of the state of the polished surface. As a result, the state of the polished surface is observed using the light that passes through the part 33a of the window plate 31 (among the light that is emitted from the polished-state measuring device 23, reflected by the polished surface of the silicon wafer 17 and returned to the polished-state measuring device 23). A position detection sensor (not shown in the figures) is installed on the platen 20 in the same manner as in the polishing apparatus described in Working Configuration 1-2. The time interval required for the platen 20 to rotate from the position of the platen 20 at which the position detection sensor outputs a trigger signal to the position at which the part 33a of the window plate 31 installed in the opening part reaches a point above the polished-state measuring device 23 is determined by the rpm of the platen 20. Accordingly, as in Working Configuration 1-2, the above-mentioned time interval can be calculated or measured beforehand, and the polished-state measuring device 23 can be actuated after this time interval has elapsed following the output of the trigger signal by the position detection sensor.

In this working configuration, as in Working Configuration 1-2, the polishing process and dressing process are repeated. Each time dressing is performed, the surface of the polishing body 21 is ground away, so that the amount of recess in the part 33a of the window plate 31 in the opening part 32 with respect to the surface of the polishing body 21 becomes progressively smaller. When the amount of recess reaches zero, scratching of the part 33a of the window plate 31 begins to be caused by dressing. As a result, the scattering, etc., of light in the part 33a increases, so that the precision of polishing endpoint detection and the precision of film thickness measurement drop.

Accordingly, a switch is made so that polishing endpoint detection or film thickness measurement is accomplished using the part 33b of the window plate 31, in which the amount of recess in the initial state is second smallest. Such a switch so that polishing endpoint detection or film thickness measurement is performed using the part 33b of the window plate 31 can be accomplished by changing the time interval from the output of the trigger signal by the position detection sensor installed on the platen 20 to the actuation of the polished-state measuring device 23 to the appropriate time interval, and actuating the polished-state measuring device 23 when the part 33b of the window plate 31 arrives at a point above the polished-state measuring device 23.

Then, the polishing process and dressing process are repeated, and when the amount of recess of the part 33b of the window plate 31 also reaches zero, so that scratching of the part 33b of the window plate 31 begins to be caused by dressing, another switch is made so that polishing endpoint detection or film thickness measurement is accomplished using the part 33c, which has the largest amount of recess of any part of the window plate 31 in the initial state. Thus, since the surfaces (on the side of the object of polishing) of respective parts of the window installed in the opening part that are used for polishing endpoint detection and film thickness measurement are recessed with respect to the surface of the polishing body during dressing, there is no scratching of these parts during dressing.

Furthermore, in the present working configuration, the polishing body 21 has a step-form window plate 31 whose surface has three steps in the opening part. However, the number of steps may also be two steps, or four or more steps. In such cases, the observation of the polished state can be switched a number of times corresponding to the number of steps.

In a polishing apparatus which uses the polishing body of such a working configuration, a window with a step-form surface is installed in the polishing body; accordingly, even if one part of the window should be scratched by dressing so that this part of the window becomes optically opaque, polishing endpoint detection or film thickness measurement can be accomplished by switching the part of the window used for the observation by the polished-state measuring device 23. As a result, the same polishing body can be used in polishing for a longer period of time than is possible in the case of a conventional [polishing body], so that the frequency of replacement of the polishing body or windows is reduced, thus making it possible to reduce the cost of polishing.

In the polishing apparatus of this working configuration, it would also be possible to perform the switching of the parts of the window plate 31 by installing a control device that switches to the next opening part when the amount of light received by the polished-state measuring device 23 drops below a predetermined set value, as in Working Configuration 1-2.

[Working Configuration 1-4]

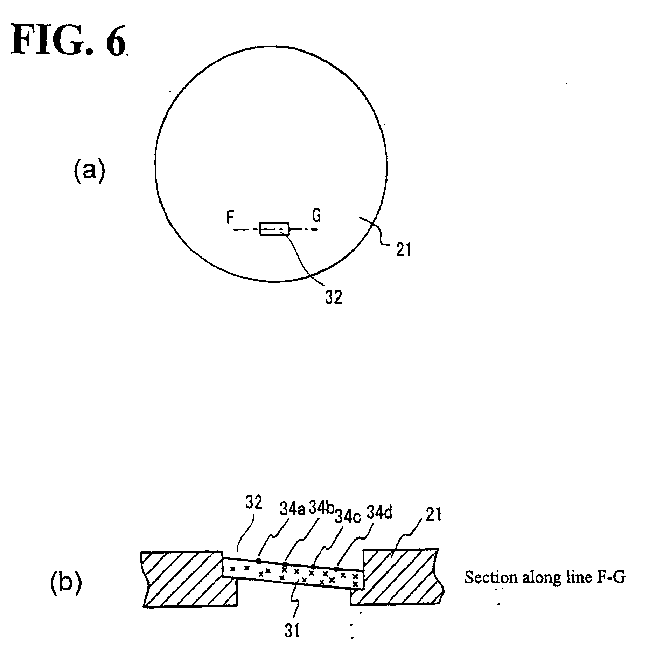

Figure 6 is a diagram which is used to illustrate a fourth example of a polishing pad (polishing body) that constitutes a working configuration of the present invention. Figure 6 (a) is a plan view, and Figure 6 (b) is a sectional view of the portion indicated by line F-G in Figure 6 (a). In Figure 6, 34a through 34d are points on the surface of the window plate 31.

The polishing body 21 of the present working configuration has a single opening part. The parallel flat-plate window plate 31 installed in this opening part is devised so that it is inclined in section, with the amount of recess from the surface of the polishing body varying in the F-G direction in Figure 6 (a). As a result, the amount of recess of the surface of the window plate 31 on the side of the object of polishing varies in a continuous manner. In a case where four places 34a, 34b, 34c and 34d are designated on the surface of the window plate 31, the amount of recess of the surface of the window on the side of the object of polishing with respect to the surface of the polishing body is smallest in the area of 34a, second smallest in the area of 34b, third smallest in the area of 34c, and greatest in the area of 34d.

Such a polishing body 21 is used as the polishing body of the polishing apparatus shown in Figure 2. In this case as well, [the apparatus is arranged] so that the opening part 22 in the platen 20 is superimposed on the opening part 32 in the polishing body 21.

In the initial state immediately following the initiation of polishing, the area of 34a in which the amount of recess of the surface of the window 41 on the side of the object of polishing with respect to the surface of the polishing body is smallest is used for the observation of the state of the polished surface. As a result, the state of the polished surface is observed using the light that passes through the area of 34a on the window plate 31 (among the light that is emitted from the polished-state measuring device 23, reflected by the polished surface of the silicon wafer 17 and returned to the polished-state measuring device 23). A position detection sensor (not shown in the figures) is installed on the platen 32 in the same manner as in the polishing apparatus according to Working Configuration 1-2. The time interval required for the platen 20 to rotate from the position of the platen 20 at which the position detection sensor outputs a trigger signal to the position at which the area of 34a on the window 32 installed in the opening part reaches a point above the polished-state measuring device 23 is determined by the rpm of the platen 20. Accordingly, as in Working Configuration 1-2, the above-mentioned time interval can be calculated or measured beforehand, and the polished-state measuring device 23 can be actuated after this time interval has elapsed following the output of the trigger signal by the position detection sensor.

Furthermore, as in Working Configuration 1-2, the polishing process and dressing process are repeated.

Each time dressing is performed, the surface of the polishing body 21 is ground away, so that the amount of recess in the area of 34a on the window plate 31 in the opening part with respect to the surface of the polishing body 21 becomes progressively smaller. When the amount of recess reaches zero, scratching of the area of 34a on the window plate 31 begins to be caused by dressing. As a result, the precision of polishing endpoint detection and the precision of film thickness measurement drop. Accordingly, a switch is made so that polishing endpoint detection or film thickness measurement is accomplished using the area of 34b on the window plate 31, in which the amount of recess is second smallest. Such a switch so that polishing endpoint detection or film thickness measurement is performed using the area of 34b on the window plate 31 can be accomplished by changing the time interval from the output of the trigger signal by the position detection sensor installed on the platen 20 to the actuation of the polished-state measuring device 23 to the appropriate time interval, and actuating the polished-state measuring device 23 when the area of 34b on the window plate 31 arrives at a point above the polished-state measuring device 23.

Then, the polishing process and dressing process are repeated, and when the amount of recess in the area of 34b on the window plate 31 also reaches zero, so that scratching in the area of 34b on the window plate 31 begins to be caused by dressing, another switch is made so that polishing endpoint detection or film thickness measurement is accomplished using the area of 34c on the window plate 31, in which the amount of recess is third smallest. Th polishing process and dressing process are then further repeated, and when amount of recess in the area of 34c on the window plate 31 also reaches zero, so that scratching in the area of 34c on the window plate 31 begins to be caused by dressing, another switch is made so that polishing endpoint detection o r film thickness measurement is accomplished using the area of 34d on the window plate 31, in which the amount of recess is largest. Thus, since the surfaces (on the side of the object of polishing) of the [above-mentioned] areas of the window installed in the opening part that are used for polishing endpoint detection or film thickness measurement are recessed with respect to the surface of the polishing body during dressing, these areas are not scratched during dressing.

Furthermore, in the present working configuration, switching was performed among four locations on the window; however, the number of locations involved in this switching may also be two or three locations, or more than four locations. In such cases, the observation of the polished state can be switched a number of times corresponding to the number of areas used for measurement.

In a polishing apparatus which uses such a polishing body, parallel flat-plate-form window is installed in the polishing body so that the surface of this window is inclined; accordingly, even if one area on the window should be scratched by dressing so that this area on the window becomes optically opaque, polishing endpoint detection or film thickness measurement can be accomplished by switching the area on the window used for the observation by the polished-state measuring device 23. As a result, the same polishing body can be used in polishing for a longer period of time than is possible in the case of a conventional [polishing body], so that the frequency of replacement of the polishing body or windows is reduced, thus making it possible to reduce the cost of polishing.

In the polishing apparatus of this working configuration, it would also be possible to perform the switching of the areas on the window plate 31 by installing a control device that switches to the next opening part when the amount of light received by the polished -state measuring device 23 drops below a predetermined set value, as in Working Configuration 1-2.

[Working Configuration 1-5]

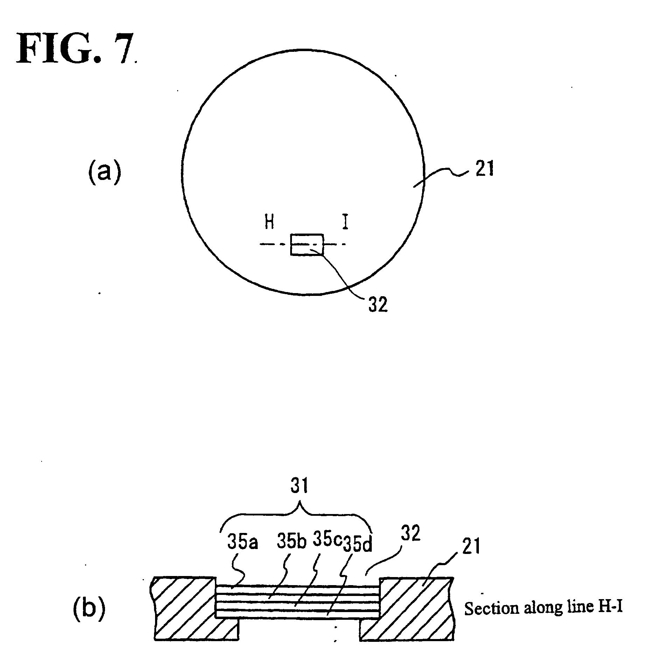

Figure 7 is a diagram which is used to illustrate a fifth example of a polishing pad (polishing body) that constitutes a working configuration of the present invention. Figure 7 (a) is a plan view, and Figure 7 (b) is a sectional view of the portion indicated by line H-I in Figure 7 (a). In Figure 7, 35a through 35d indicate sheets of a transparent material.

The polishing body 21 of the present working configuration has a single opening part 32. The parallel flat-plate-form window plate 31 which is installed in this opening part 32 has a structure in which four sheets 35a through 35d of a transparent material are laminated with an adhesive strength that allows peeling [of the sheets]. The transparent material [sheets] 35a through 35d are bonded by means of an adhesive agent or two-sided tape, etc., which has an adhesive strength that allows peeling [of the sheets]. The amount of recess of the [surface of] the window plate 31 on the side of the object of polishing with respect to the surface of the po lishing body 21 is varied in a stepwise manner by peeling away the transparent material [sheets] 35a through 35d one at a time from the top.

Such a polishing body 21 is used as the polishing body of the polishing apparatus shown in Figure 2. In this case as well, [the apparatus is arranged] so that the opening part 22 in the platen 20 is superimposed on the opening part 32 in the polishing body 21.

In the initial state immediately following the initiation of polishing, the window with four laminated transparent material sheets 35a through 35d is used for the observation of the state of the polished surface. As a result, the state of the polished surface is observed using the light that passes through the window in which these four transparent material sheets 35a through 35d are laminated (among the light that is emitted from the polished-state measuring device 23, reflected by the polished surface of the silicon wafer 17 and returned to the polished -state measuring device 23). The mechanism and method which perform polishing endpoint detection or film thickness measurement utilizing the opening parts formed in the platen 20 and polishing body 21 as the platen 20 rotates are the same as in Working Configuration 1-2; accordingly, a description is omitted here.

Furthermore, as in Working Configuration 1-2, the polishing process and dressing process are repeated. Each time dressing is performed, the surface of the polishing body is ground away, so that the amount of recess of the surface (on the side of the object of polishing) of the transparent material [sheet] 35a of the window plate 31 in the opening part with respect to the surface of the polishing body 21 decreases, and when this amount of recess reaches zero, the surface of the transparent material [sheet] 35a begins to be scratched by dressing. As a result, the scattering, etc., of light in the transparent material [sheet] 35a increases, so that the precision of polishing endpoint detection and the precision of film thickness measurement drop. Accordingly, the transparent material [sheet] 35a is peeled away from the laminated window plate 31, so that polishing endpoint detection or film thickness measurement is [subsequently] performed with the transparent material [sheet] 35b as the uppermost surface of the window. As a result, the surface of the window plate 31 that is obtained is a surface of the window plate 31 that is recessed from the surface of the polishing body 21 and that is unscratched, so that polishing endpoint detection or film thick ness measurement can be performed in a normal manner. Furthermore, since the same position on the window plate 31 of the same opening part can be used for polishing endpoint detection or film thickness measurement in the polishing apparatus of the present working configuration, there is no need to switch the window position used for polishing endpoint detection or film thickness measurement as in the polishing apparatuses of Working Configurations 1-2 through 1-4.

Then, the polishing process and dressing process are repeated, and when the amount of recess of the surface of the transparent material [sheet] 35b of the window plate 31 on the side of the object of polishing also reaches zero, so that the transparent material [sheet] 35b begins to be scratched by dressing, the transparent material [sheet] 35b is peeled from the window plate 31, so that polishing endpoint detection or film thickness measurement is [subsequently] performed with the transparent material [sheet] 35b as the uppermost surface of the window. The polishing process and dressing process are then further repeated, and when the amount of recess of the surface of the transparent material [sheet] 35c of the window plate 31 on the side of the object of polishing also reaches zero, so that the transparent material [sheet] 35c begins to be scratched by dressing, the transparent material [sheet] 35c is peeled from the window plate 31, so that polishing endpoint detection or film thickness measurement is [subsequently] performed with the transparent material [sheet] 35d as the uppermost surface of the window plate 31. Thus, since the surface (on the side of the object of polishing) of the part of the window installed in the opening part that is used for polishing endpoint detection or film thickne ss measurement is recessed with respect to the surface of the polishing body during dressing, there is no scratching of this part during dressing.

Furthermore, in order to ascertain the timing at which the parts 35a, 35b and 35c of the window are peeled away, it would also be possible to install a control device which outputs a signal that indicates the peeling timing when the amount of light received by the polished -state measuring device 23 drops below a predetermined set value.

Furthermore, [in the present working configuration,] a window is used in which four transparent material [sheets] 35a through 35d are laminated in the window plate 31; however, it would also be possible to use a window in which two or three sheets or five or more sheets of a transparent material are laminated. In such cases, the observation of the polished state can be switched a number of times corresponding to the number of transparent material [sheets] used.

Furthermore, in cases where the amount of recess of the surface of the window plate 31 on the side of the object of polishing with respect to the surface of the polishing body 21 exceeds 400 $\mu$m, the amount of polishing agent that accumulates in the recessed part becomes excessively large, and this polishing agent acts as a scattering body, so that the light 24 emitted from the polished-state measuring device 23 is attenuated, thus causing a drop in the precision of polishing endpoint detection and the precision of film thickness measurement. Accordingly, it is desirable that the amount of recess d of the portion of the window plate 31 through which the light from the polished-state measuring device 23 passes (i.e., the portion used for polishing endpoint detection or film thickness measurement) be such that $0 \mu m < d \leq 400 \mu m$. Accordingly, except for the lowermost transparent material [sheet] 35d, it is desirable that the respective thicknesses $t1$ of the transparent material [sheets] 35a through 35c that are peeled away be such that $0 \mu m < t1 \leq 400 \mu m$.

Thus, in a polishing apparatus which uses the polishing body of the present working configuration, a window in which [sheets of] a transparent material are laminated is installed in the polishing body; accordingly, even if the surface of the window on the side of the obj ect of polishing should be scratched by dressing so that this surface becomes optically opaque, polishing endpoint detection or film thickness measurement can be accomplished by peeling away the transparent material [sheet] constituting the uppermost layer of the laminated window. As a result, compared to conventional [polishing bodies], the same polishing body can be used in polishing for a long period of time, so that the frequency of replacement of the polishing body or window can be reduced; accordingly, the cost of polishing can be reduced.

In the above-mentioned Working Configurations 1-1 through 1-5, it is desirable that the material of the polishing pad (polishing body) consist of one or more materials selected from a set consisting of epoxy resins, acrylic resins, ABC resins, vinyl chloride resins, polycarbonate resins, polyester resins, fluororesins and polyurethane resins.

A transparent material such as glass, quartz glass, acrylic, polyurethane, epoxy, PET, vinyl chloride, polycarbonate, polyester or silicone rubber, etc., is used as the window plate material. Furthermore, it is desirable that the polishing characteristics (polishing rate and hardness, etc.) of such transparent materials be comparable to the polishing characteristics of the polishing body. In this way, even if the window should contact the silicon wafer constituting the object of polishing, there will be no non -uniform polishing or scratching of the polished surface of the silicon wafer by the window.

[Working Configuration 1-6]

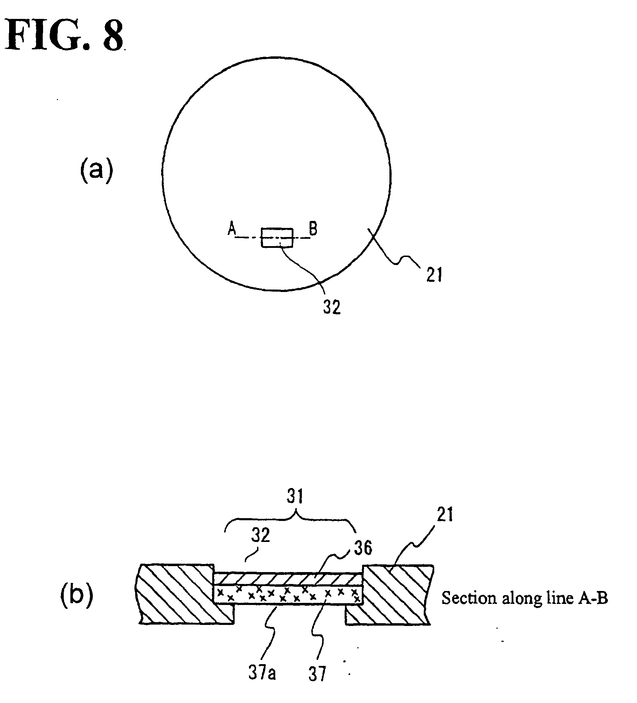

Figure 8 is a diagram which is used to illustrate a sixth example of a polishing pad (polishing body) that constitutes a working configuration of the present invention. Figure 8 (a) is a plan view, and Figure 8 (b) is a sectional view of the portion indicated by line A-B in Figure 8 (a). In Figure 8, 36 indicates an upper transparent material sheet, and 37 indicates a lower transparent material sheet.

In this working configuration, a window plate 31 in which two transparent material [sheets], i.e., an upper transparent material [sheet] 36 and a lower transparent material [sheet] 37, are laminated is installed in an opening part 32 formed in the polishing body (polishing pad) 21. The upper transparent material [sheet] 36 is a transparent material [sheet] located on the side of the object of polishing, and the lower transparent material [sheet] 37 is a transparent material [sheet] located on the opposite side from the object of polishing.

A transparent material such as a polyurethane, acrylic, polycarbonate, polystyrene, vinyl chloride, polyethylene terephthalate, polyester or epoxy, etc., is used as the upper transparent material [sheet] 36.

A transparent material such as glass, acrylic, polycarbonate, polystyrene, vinyl chloride, polyethylene terephthalate, polyester or epoxy, etc., is used as the lower transparent material [sheet] 37.

One or more materials selected from a set consisting of epoxy resins, acrylic resins, ABC resins, vinyl chloride resins, polycarbonate resins, polyester resins, fluororesins and polyurethane resins are desirable as the material of the polishing pad (polishing body) 21.

In the present working configuration, two sheets of transparent materials are laminated in the window; however, the number of sheets of transparent materials that are laminated may also be three or more sheets.

It is desirable that the compressive elastic modulus of the upper transparent material [sheet] 36, which is the transparent material [sheet] located on the side of the object of polishing, be smaller than the compressive elastic modulus of the lower transparent material [sheet] 37, which is the polishing material [sheet] located on the opposite side from the object of polishing. As a result, since the lower polishing material [sheet] 37 of the window is hard, it shows little deformation, so that there is no instability in polishing endpoint detection or instability in film thickness measurement caused by deformation of the window.

Furthermore, since the lower polishing material [sheet] 37 of the window is hard, an anti-reflection film can be formed on the surface 37a of the lower polishing material [sheet] 37. As a result of the formation of such an anti-reflection film, the reflection by the surface of the window of the light that passes through the window and is used for the measurement of the polished state is reduced, so that the attenuation of the intensity of this light is reduced; accordingly, there is no drop in the precision of polishing endpoint detection or the precision of film thickness measurement. It is therefore desirable that an anti-reflection film be formed on the surface 37a of the lower polishing material [sheet] 37, which is the surface on the opposite side of the window from the object of polishing.

It is desirable that the compressive elastic modulus of the upper transparent material [sheet] 36, which is the transparent material [sheet] located on the side of the object of polishing, be approximately the same as the compressive elastic modulus of the polishing body 21. The compressive elastic modulus of a common polishing body is in the range of $2.9 \times 10^7$ Pa to $1.47 \times 10^9$ Pa. Accordingly, it is desirable that the compressive elastic modulus e of the upper transparent material [sheet] 36, which is the transparent material [sheet] located on the side of the object of polishing, be such that $2.9 \times 10^7$ Pa $\leq e \leq 1.47 \times 10^9$ Pa. As a result, there is no scratching of the object of polishing when the window contacts the object of polishing.

It is desirable that the surface of the window plate 31 on the side of the object of polishing be recessed with respect to the surface of the polishing body 21 that is contacted by the silicon wafer 17 that constitutes the object of polishing. In this way, contact between the silicon wafer and the window plate 31 is eliminated, so that there is no scratching of the silicon wafer or scratching of the surface of the window plate 31. As a result of this elimination of scratching of the surface of the window, there is no increase in the attenuation of the light 24 emitted from the polished-state measuring device 23; accordingly, there is no drop in the precision of polishing endpoint detection or the precision of film thickness measurement.

Furthermore, the above-mentioned anti-reflection film can also be formed on the undersurfaces of the window plates 31 in the above-mentioned Working Configurations 1-1 through 1-5.

In the above-mentioned Working Configurations 1-2 through 1-6 as well, the amount of polishing agent that accumulates in the recessed area becomes excessively large in cases where the amount of recess of the surface of the window on the side of the object of polishing with respect to the surface of the polishing body exceeds 400 $\mu$m. [In such cases,] the polishing agent constitutes a scattering body, and causes attenuation of the light 24 that is emitted from the polished-state measuring device 23, so that the precision of polishing endpoint detection and precision of film thickness measurement drop. Accordingly, it is desirable that the amount of recess d of the portion of the window through which the light from the polished-state measuring device 23 passes (i.e., the portion used for polishing endpoint detection or film thickness measurement) be such that 0 $\mu$m < $d \leq$ 400 $\mu$m. Furthermore, it is even more desirable that [this amount of recess d be] such that 10 $\mu$m < $d \leq$ 200 $\mu$m.

Furthermore, in all of the above-mentioned working configurations, the windows become [too] thin if the thickness of the window plates is less than 10% of the thickness of the polishing body, so that there is a danger that the windows will undergo deformation. If the windows undergo deformation so that the windows are optically distorted, the windows will function as lenses, etc., as a result of this distortion; as a result, the problem of unstable polishing endpoint detection and film thickness measurement arises. Accordingly, it is desirable that the above-mentioned amount of recess be no more than 90% of the thickness of the polishing body, so that the thickness of the thinnest portions of the windows is 10% of the thickness of the polishing body or greater. As a result, there is no instability in polishing endpoint detection or instability in film thickness measurement caused by distortion of the windows.

In the above-mentioned Working Configurations 1-1 through 1-6, the window plates 31 are directly installed in the opening parts 32 of the [respective] polishing bodies 21. However, it is not necessary that the windows be directly installed in the polishing body 21. For example, it would also be possible to install the windows in the platen 20 either directly or via a jig, so that at least portions of the opening parts in the polishing body 21 are closed off.

Furthermore, in Working Configurations 1-2 through 1-6, the hole shape of the opening parts 31 formed in the [respective] polishing bodies 21 is a step-form shape; however, these opening parts may also be rectilinear through-holes.

Furthermore, in the above-mentioned Working Configurations 1-1 through 1-6, it is desirable that the transmissivity of the window plates 31 be 22% or greater. In this way, the attenuation of the intensity of the light that is used to measure the polished state via the window plates 31 is reduced, so that there is no drop in the polishing endpoint detection precision or film thickness measurement precision.

Furthermore, in the above-mentioned Working Configurations 1-1 through 1-6, it is desirable that the intensity of the light 24 emitted from the po lished-state measuring device 23 and the intensity of the light that [i] is emitted from the polished-state measuring device 23, [ii] passes through the window plate 31, [iii] passes through the polishing agent 19 between the window plate 31 and the silicon wafer 14, [iv] is reflected by the polished surface of the silicon wafer 17, [v] again passes through the polishing agent 19 between the window plate 31 and the silicon wafer 17, [vi] again passes through the window plate 31, and [vii] returns to the polished-state measuring device 23, be 1% or more of the intensity of the light 24 that is emitted form the polished-state measuring device 23. In this way, there is no drop in the intensity of the light that returns to the polished-state measuring device; accordingly, there is no drop in the polishing endpoint detection precision or film thickness measurement precision caused by the polished-state measuring device.

Furthermore, in the above-mentioned Working Configurations 1-1 through 1-6, dressing of the polishing body is performed; however, in cases where a non-foam material is used in the polishing body, there may be cases in which dressing is unnecessary. Even in cases where such a polishing body that does not require dressing is used, the surface of the polishing body is ground away as the object of polishing is polished. Accordingly, by using the above-mentioned Working Configurations 1-1 through 1-6, the frequency of replacement of the windows or polishing body can be reduced, so that the cost of polishing can be reduced.

[Embodiment 1-1]

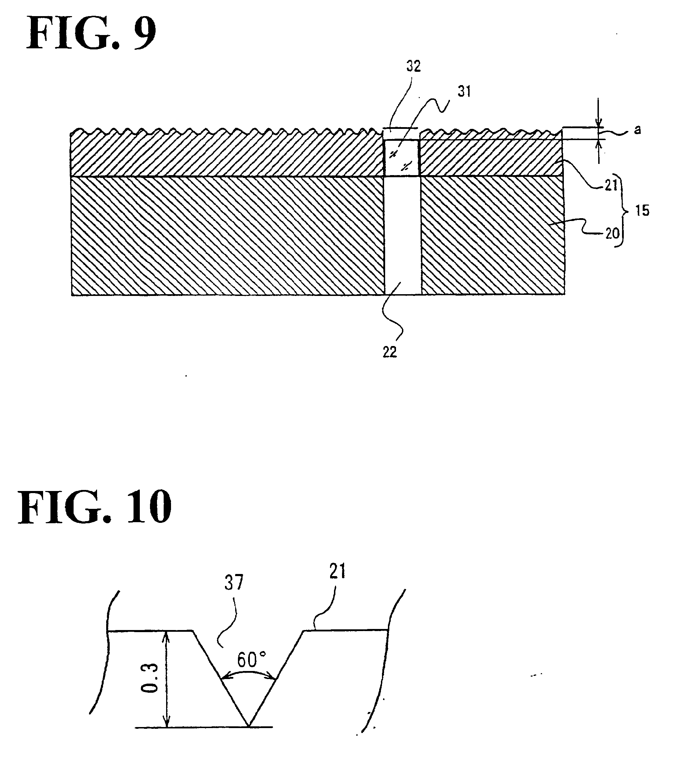

Figure 9 is a diagram which is used to illustrate a first example of a polishing pad (polishing body) constituting an embodiment of the present invention.

In regard to the materials used, epoxy principal agents Epicote 828 and Epicote 871 (both manufactured by Yuka Shell Epoxy K.K.) and a diaminodiphenylmethane curing agent were mixed and agitated at a weight ratio of 2.6 : 3.9 : 1, and this mixture was caused to flow into onto an aluminum plate with a diameter of 800 mm which had a mold with hole parts as the observation window parts. The mixture was then cured by being heated for 8 hours at 150 °C, thus producing a polishing pad (polishing body) 21.

Next, a spiral V-shaped groove (angle of V: 60°) with a pitch of 0.5 mm and a depth of 0.3 mm and lattice-form grooves with a pitch of 15 mm, a width of 2 mm and a depth of 0.5 mm were formed in the surface of the above-mentioned epoxy resin by cutting. Figure 10 shows a sectional view of the V-shaped groove 37 (angle of V: 60°) in this polishing pad 21.

The thickness of the resin part of this polishing pad 21 was 2 mm, and the amount of compressive deformation was 2 $\mu$m in the case of a load of 10 kgf/cm$^2$ (9.8 $\times$ 10$^5$ Pa).

An acrylic material was selected as the material of the window plate 31, and a hard coating with a thickness of approximately 1 $\mu$m was formed by coating this acrylic material with a hard coating liquid prepared by dispersing colloidal silica in a partial co-hydrolyzate of a universally known epoxysilane, and curing this liquid by heating. As is shown in Figure 9, [the window plate 31] was inserted and fastened in the hole part of the molded polishing pad so that the hard-coated side of the window plate 31 faced toward the uppermost layer of the polishing pad, and so that the gap $a$ was 100 $\mu$m in the loaded/compressed state. The transmissivity of the window plate 31 and slurry (SS25 manufactured by Cabot Co., diluted 2X) with respect to the measurement light when the opening part 32 formed above the window plate 31 was filled with the slurry was 89%.

This polishing pad 21 was bonded to the surface of a platen 20, so that a polishing member 15 was constructed. Using a polishing apparatus of the type shown in Figure 2, a six-inch silicon wafer on which a thermal oxidation film had been formed to a thickness of 1 $\mu$m was held on the polishing head 16, and polishing was performed under the following conditions:

Polishing head rpm: 50 rpm
Platen rpm: 20 rpm
Load: 460 g/cm$^2$ (4.5 $\times$ 10$^4$ Pa)
Oscillation width: 30 mm
Oscillation rate: 15 strokes/min
Polishing time: 3 min
Slurry used: SS25 diluted 2X
Slurry flow rate: 200 ml/min

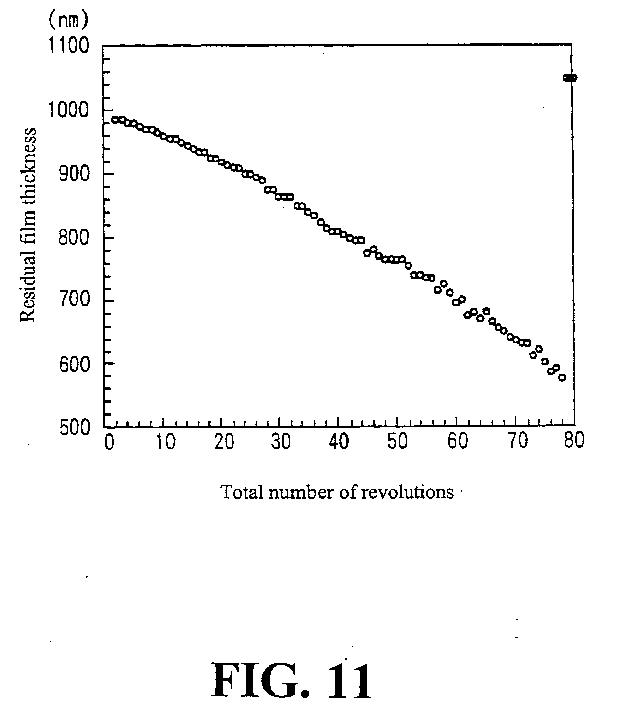

During polishing, a polishing rate of 100 nm/min was observed by in-situ optical measurement of the residual film thickness via the window plate used for observation as shown in Figure 11. The stability of this measurement was confirmed as a result of repeated measurements.

Furthermore, no deleterious effects such as non-uniformity of polishing or scratching were caused by the measurement window.

[Embodiment 1-2]

A polishing body of the type shown in Figure 4 was manufactured. Here, a two-layer polishing body (hereafter referred to as "IC1000/SUBA400") in which the lower layer of the polishing body 21 consisted of SUBA400 manufactured by Rodel Co., and the upper layer consisted of IC1000 manufactured by Rodel Co., was used.

Window plates 31a, 31b and 31c consisting of a polyurethane were respectively installed so that the amount of recess of the surface of the window on the side of the object of polishing from the surface of the polishing body was 0.15 mm in the case of the opening part 32a, 0.3 mm in the case of the opening part 32b, and 0.45 mm in the case of the opening part 32c.

This polishing body was used in the polishing apparatus shown in Figure 2, and a six-inch silicon wafer on which a thermal oxidation film had been formed to a thickness of 1 μm was polished under the conditions shown below. The residual film thickness on the silicon wafer was measured in situ by means of the polished-state measuring device 23 using the window plate 31 a in the opening part 32a.

Polishing head rpm: 50 rpm
Platen rpm: 50 rpm
Load applied to polishing head: $2.4 \times 10^4$ Pa
Oscillation of polishing head: none
Polishing time: 90 sec
Polishing agent used: SS25 manufactured by Cabot Co., diluted 2X with ion exchange water
Polishing agent flow rate: 200 ml/min

The mean polishing rate in this case was 430 nm/min. Following the completion of polishing, dressing was performed for 1 minute using a diamond grinding wheel with an abrasive grain size of #100.

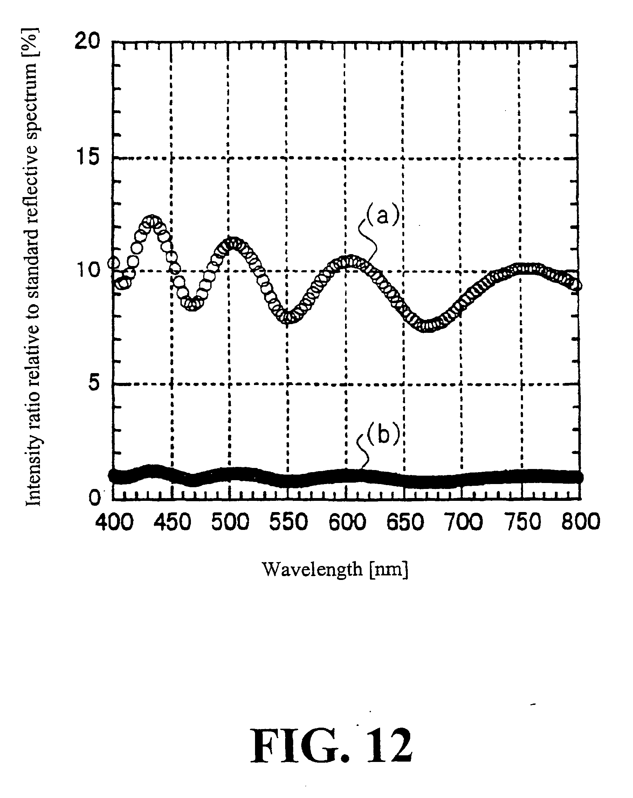

The above-mentioned polishing process and dressing process were repeated, with a fresh six-inch silicon wafer on which a thermal oxidation film had been formed to a thickness of 1 μm being used each time. Figure 12 is a graph which shows the reflective spectrum from the surface of the silicon wafer measured in situ at a certain instant during polishing. Among the curves shown in the graph of Figure 12, curve (a) indicates the reflective spectrum that was obtained. In the graph shown in Figure 12, the horizontal axis indicates wavelength, while the vertical axis indicates the intensity ratio of the measured reflective spectrum to a standard reflective spectrum obtained in a case where a silicon wafer on which an aluminum film had been formed was installed on top of the window part of the polishing body in a state in which ion exchange water was interposed instead of the polishing agent, with the reflective spectrum of the light returning to the polished-state measuring device 23 being taken as the [above-mentioned] standard reflective spectrum. In-situ measurement of the residual film thickness of the thermal oxidation film on the silicon wafer was possible by means of wavelength fitting using a simulation.

However, the window began to be scratched by dressing following the polishing of the 120th silicon wafer, and the reflective spectrum obtained after the polishing of the 150th silicon wafer was as indicated by curve (b) in Figure 12, so that the probability of error being generated in the in-situ measurement became large.

Then, when in-situ measurement was performed after a switch was made to the window plate 31b in the opening part 32b in which the amount of recess in the initial state was 0.3 mm, [it was found that] error-free in-situ measurement was possible as before.

Furthermore, when a dressing treatment was performed following the polishing of the 260th silicon wafer, scratching occurred in the window plate 31b of the opening part 32b, and with the polishing of the 280 silicon wafer, measurement became difficult as a result of a drop in the transmissivity of the window plate 31b.

When in-situ measurement was again performed following a switch to the window plate 31c in the opening part 32c, in which the amount of recess in the initial state was 0.45 mm, [it was found that] in-situ measurement was possible as before. Finally, in the case of the window plate 31c in the opening part 32c, in-situ measurement was possible up to the polishing process and dressing process of the 450th silicon wafer.

[Embodiment 1-3]

A polishing body of the type shown in Figure 5 was manufactured. An IC1000/SUBA400 polishing body manufactured by Rodel Co., was used as this polishing body, and an opening part 32 was formed in one place in this polishing body 21. A window plate 31 consisting of a polyurethane was installed in this opening part 32. [This window plate 31] was arranged so that the amount of recess of the surface of the window plate 31 on the side of the object of polishing with respect to the surface of the polishing body 21 was respectively 0.15 mm, 0.3 mm and 0.45 mm in the respective parts 33a, 33b and 33c [of the window plate 31].

Afterward, the above-mentioned polishing body 21 was installed on the platen of a polishing apparatus of the type shown in Figure 2. A six-inch silicon wafer on which a thermal oxidation film had been formed to a thickness of 1 μm was polished under the conditions shown below, and the residual film thickness on the silicon wafer was measured in situ by means of the polished-state measuring device 23 using the part 33a of the window plate 31.

Polishing head rpm: 50 rpm
Platen rpm: 50 rpm
Load applied to polishing head: $2.4 \times 10^4$ Pa
Oscillation of polishing head: none
Polishing time: 90 sec
Polishing agent used: SS25 manufactured by Cabot Co., diluted 2X with ion exchange water
Polishing agent flow rate: 200 ml/min

The mean polishing rate in this case was 430 nm/min. Follo wing the completion of polishing, dressing was performed for 1 minute using a diamond grinding wheel with an abrasive grain size of #100.

When the above-mentioned polishing process and dressing process were repeated using a fresh six-inch silicon wafer on which a thermal oxidation film had been formed to a thickness of 1 μm each time, the part 33a of the window plate 31 began to be scratched by dressing following the polishing of the 120th silicon wafer, and with the polishing of the 150th [silicon wafer], the probability of error being generated in the in-situ measurement increased as a result of a drop in the transmissivity of the part 33a of the window plate 31.

Then, when in-situ measurement was performed following a switch to the part 33a, in which the amount of recess in the initial state was 0.3 mm, [it was found that] error-free in-situ measurement was possible as before.

Furthermore, when a dressing treatment was performed following the polishing of the 260th silicon wafer, the part 33b of the window plate 31 began to be scratched, and with the polishing of the 280th silicon wafer, the probability of error being generated in the in-situ measurement increased as a result of a drop in the transmissivity of the part 33b of the window plate 31.

When in-situ measurement was again performed following a switch to the part 33c of the window plate 31, in which the amount of recess in the initial state was 0.45 mm, [it was found that] error-free in-situ measurement was possible as before.

Finally, in the case of the part 33c of the window plate 31, in-situ measurement was possible up to the polishing treatment of the 450th silicon wafer.

[Embodiment 1-4]

A polishing body of the type shown in Figure 6 was manufactured. An IC1000/SUBA400 polishing body manufactured by Rodel Co., was used as this polishing body 21, and an opening part was formed in one place in this polishing body.

A window plate 31 consisting of a polyurethane was installed at an inclination as shown in Figure 6. [This window plate 31] was arranged so that the amount of recess of the surface of the window plate 31 on the side of the object of polishing with respect to the surface of the polishing body 21 was a minimum of 0.1 mm (in the area of 34a) and a maximum of 0.5 mm (in the area of 34d).

Using this polishing body as the polishing body in a polishing apparatus of the type shown in Figure 2, a six-inch silicon wafer on which a thermal oxidation film had been formed to a thickness of 1 $\mu$m was polished under the conditions shown be low. The residual film thickness on the silicon wafer was measured in situ by means of the polished-state measuring device 23 using the area of 34a on the window plate 31.

 Polishing head rpm: 50 rpm
 Platen rpm: 50 rpm
 Load applied to polishing head: $2.4 \times 10^4$ Pa
 Oscillation of polishing head: none
 Polishing time: 90 sec
 Polishing agent used: SS25 manufactured by Cabot Co., diluted 2X with ion exchange water
 Polishing agent flow rate: 200 ml/min

The mean polishing rate in this case was 430 nm/min. Following the completion of polishing, dressing was performed for 1 minute using a diamond grinding wheel with an abrasive grain size of #100.

When the above-mentioned polishing process and dressing process were repeated using a fresh six-inch silicon wafer on which a thermal oxidation film had been formed to a thickness of 1 $\mu$m each time, the transmissivity in the area of 34a on the window plate 31 dropped as a result of dressing following the polishing of the 50th silicon wafer, and with the polishing of the 70th silicon wafer, the probability of error being generated in the in-situ measurement increased as a result of the drop in transmissivity.

Then, when in-situ measurement was performed following a switch to the area of 34b, in which a transmissivity comparable to that obtained at the initiation of polishing could be obtained, [it was found that] in-situ measurement was possible as before.

Furthermore, when dressing was performed following the polishing of the 110th silicon wafer, there was a drop in the transmissivity, and with the [polishing of the] 140th silicon wafer, the probability of error being generated in the in-situ measurement increased as a result of the drop in transmissivity.

When in-situ measurement was again performed following a switch to the area of 34c of the window plate 31, in which a transmissivity comparable to that obtained at the initiation [of polishing] could be obtained, [it was found that] error-free in-situ measurement was possible as before.

The above-mentioned operation was repeated, and in-situ measurement was ultimately possible up to the polishing treatment of the 650th silicon wafer.

[Embodiment 1-5]

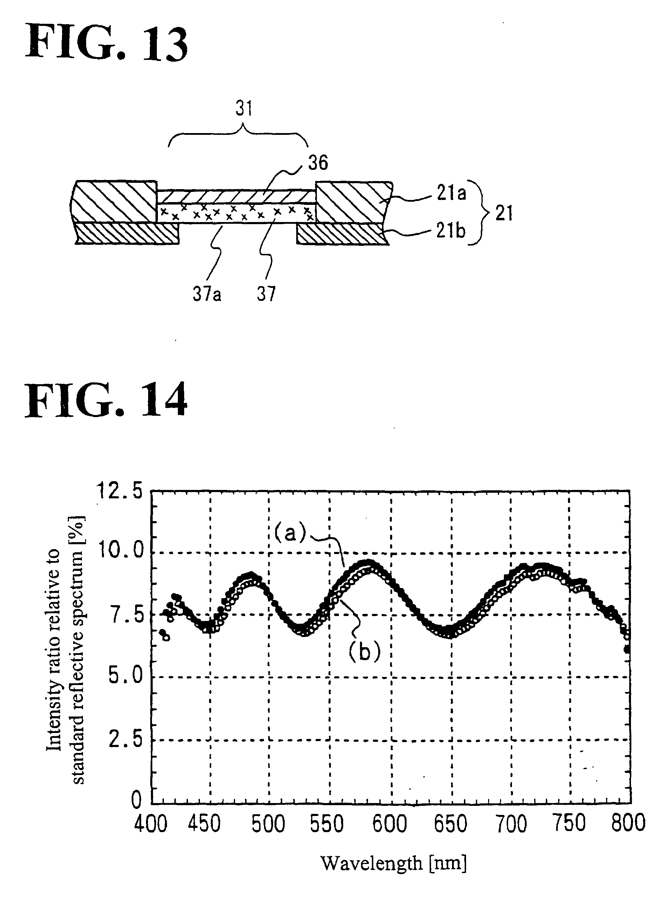

A polishing body of the type shown in Figure 13 was manufactured. An upper transparent material [sheet] 37 consisting of a polyurethane [sheet] with a size of 20 mm $\times$ 50 mm and a thickness of 0.6 mm was fastened by means of a UV adhesive agent to the upper surface of a lower transparent material [sheet] 37 (of the same size and with a thickness of 0.5 mm) on which an anti-reflection film was formed, thus forming a two-layer window. In this case, the window 31 as a whole had a size of 20 mm $\times$ 50 mm and a thickness of 1.15 mm. The anti-reflection film was formed on the surface 37a of the acrylic sheet constituting the lower transparent material [sheet] 37.

A 20 mm $\times$ 50 mm opening part was formed in an IC1000 polishing body (21 a) manufactured by Rodel Co., and a 10 mm $\times$ 40 mm opening part was formed in an SUBA400 sub-polishing body (21b). A two-layer polishing body 21 was formed by laminating the above-mentioned polishing bodies so that the centers of the respective opening parts coincided. The compressive elastic modulus of the IC1000 polishing body was $7.5 \times 10^7$ Pa, the compressive elastic modulus of the SUBA400 sub-polishing body was $9.6 \times 10^6$ Pa, the compressive elastic modulus of the acrylic was $0.29 \times 10^{10}$ Pa, and the compressive elastic modulus of the polyurethane was $7.5 \times$

$10^7$ Pa.

Next, the window which was manufactured in advance was installed by being bonded in the opening part of the polishing body 21 using a two -sided tape with a thickness of 0.1 mm. In this case, the amount of recess of the surface of the window with respect to the surface of the polishing body was 10 $\mu$m or less.

This polishing body was attached to a polishing apparatus of the type shown in Figure 2, and a six-inch silicon wafer on which a thermal oxidation film was formed to a thickness of 1 $\mu$m was polished under the conditions shown below. The residual film thickness of the oxidation film on the silicon wafer was measured in situ.

Polishing head rpm: 50 rpm
Polishing platen rpm: 50 rpm
Load (pressure with which the object of polishing was pressed against the polishing body): 2.4 $\times$ $10^4$ Pa
Oscillation: none, Polishing time: 90 sec
Polishing agent used: SS25 manufactured by Cabot Co., diluted 2X with ion exchange water
Polishing agent flow rate: 200 ml/min

The mean polishing rate in this case was 430 nm/min. In this case, there was no scratching of the silicon wafer or non-uniform polishing caused by the window. Figure 14 is a graph of reflective spectra from the surface of the silicon wafer measured in situ. Among the curves shown in the graph of Figure 14, curve (a) is the reflective spectrum of the present embodiment.

In the graph shown in Figure 14, the horizontal axis indicates wavelength, while the vertical axis indicates the intensity ratio of the measured reflective spectrum to a standard reflective spectrum obtained in a case where a silicon wafer on which an aluminum film had been formed was installed on top of the window part of the polishing body in a state in which ion exchange water was interposed instead of the polishing agent, with the reflective spectrum of the light returning to the polished -state measuring device 23 being taken as the [above-mentioned] standard reflective spectrum. Measurement of the polished state (i.e., the residual film thickness of the thermal oxidation film on the silicon wafer) was possible by means of wavelength fitting using a simulation.

[Embodiment 1-6]

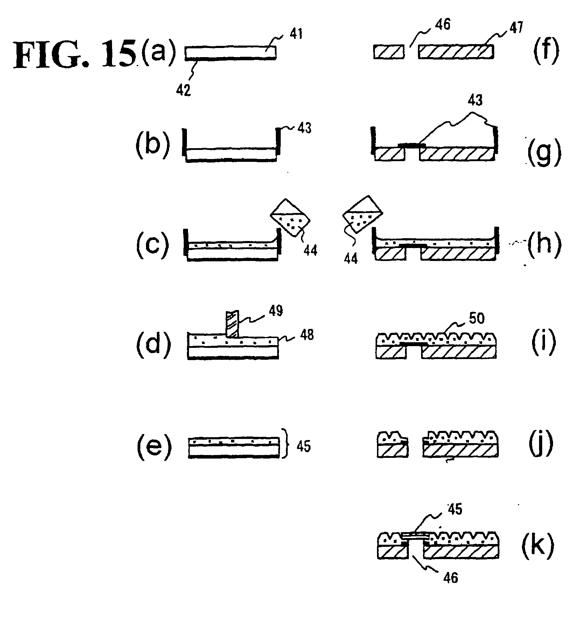

A polishing body was manufactured by a process of the type shown in Figure 15.

A quartz glass substrate 41 with a size of 20 mm $\times$ 50 mm and a thickness of 1 mm, on which an anti-reflection film 42 was formed, was prepared (Figure 15 (a)). A heat-resistant tape 43 was wrapped around the periphery of this quartz glass substrate 41, thus forming a vessel with a quartz glass bottom surface (Figure 15 (b)). A resin 44 formed by mixing Epicote 828 and Epicote 871 (manufactured by Yuka Shell Epoxy K.K.) at a weight ratio of 4 : 6, and mixing a dissolving p,p'-methylenedianiline (as a curing agent) with this mixture in an amount equivalent to the epoxy, was poured into the above-mentioned vessel and cured by heating (Figure 15 (c)). Next, after the epoxy resin 48 was cut away parallel to the quartz glass by means of a bit 49, etc., (Figure 6 (d)), the epoxy resin 44 was worked to a mirror surface by polishing, thus producing a window 45 consisting of [the above-mentioned] anti-reflection film/quartz glass/epoxy resin (in that order from the bottom) (Figure 15 (e)). In this case, the thickness of the window was 1.6 mm.

An aluminum plate 47 with an opening part 46 was prepared [(Figure 15 (f))], and a heat-resistant tape 43 was bonded to the opening part and periphery of this aluminum plate 47 (Figure 15 (g)). An epoxy resin 44 of the same composition as that used in the manufacture of the window 45 was then poured in to [produce a resin layer with] a thickness of 4 mm, and this resin was cured by heating (Figure 15 (h)). Afterward, in order to form the worked epoxy resin 50 into a polishing body, the heat-resistant tape on the periphery was removed, and a specified groove pattern was formed in the surface of the polishing body by mechanical cutting (Figure 15 (i)).

Next, a step-form hole was formed in the opening part with the size adjusted so that the surface of the above-mentioned window would be at the same height as the surface of the polishing body (Figure 15 (j)), and the window was fastened in place by means of a two-sided tape (Figure 15 (k)). The amount of recess of the surface of the window with respect to the surface of the polishing body in this case was less than 10 $\mu$m, so that the surface of the window and the surface of the polishing body constituted more or less the same surface.

In [this] embodiment, an aluminum plate with an opening part 46 was used as the aluminum plate; however, it would also be possible to use an aluminum plate that does not have an opening part, and to form an opening part in the aluminum plate at the same time that an opening part is formed in the polishing body in the process shown in Figure 15 (j).

In [this] embodiment, quartz glass was used as the lower transparent material, and an epoxy resin was used as the upper transparent material. The compressive elastic modulus of the epoxy resin was 1.47 $\times$ $10^9$ Pa, and the compressive elastic modulus of the quartz glass was 7.31 $\times$ $10^{10}$ Pa.

The polishing body thus manufactured was attached to a polishing apparatus of the type shown in Figure 2, and a six-inch silicon wafer on which a thermal oxidation film was formed to a thickness of 1 $\mu$m was polished under the conditions shown below. The residual film thickness of the oxidation film on the silicon wafer was measured in situ.

Polishing head rpm: 50 rpm
Polishing platen rpm: 50 rpm
Load (pressure with which the object of polishing was pressed against the polishing body): 2.4 $\times$ $10^4$ Pa

Oscillation: none
Polishing time: 90 sec
Polishing agent used: SS25 manufactured by Cabot Co., diluted 2X with ion exchange water
Polishing agent flow rate: 200 ml/min

The mean polishing rate in this case was 210 nm/min. Furthermore, there was no scratching of the silicon wafer or non-uniform polishing caused by the window. Moreover, the reflective spectrum from the surface of the silicon wafer obtained by in-situ measurement is curve (b) in Figure 14. Measurement of the polished state (i.e., the residual film thickness of the thermal oxidation film on the silicon wafer) was possible by means of wavelength fitting using a simulation.

[Comparative Example 1-1]

An IC1000/SUBA400 polishing body manufactured by Rodel Co., was used as a polishing body; an opening part was formed in one place in this polishing body. A window consisting of a polyurethane was installed in the opening part of the polishing body so that the amount of recess of the surface of the window on the side of the object of polishing from the surface of the polishing body was 10 $\mu$m or less.
This polishing body was installed in a polishing apparatus of the type shown in Figure 2, and a six-inch silicon wafer on which a thermal oxidation film was formed to a thickness of 1 $\mu$m was polished under the conditions shown below. The re sidual film thickness on the silicon wafer was measured in situ.

Polishing head rpm: 50 rpm
Platen rpm: 50 rpm
Load applied to polishing head: 2.4 $\times$ 10$^4$ Pa
Oscillation of polishing head: none
Polishing time: 90 sec
Polishing agent used: SS25 manufactured by Cabot Co., diluted 2X with ion exchange water
Polishing agent flow rate: 200 ml/min

The mean polishing rate in this case was 430 nm/min.
When dressing was performed for 1 minute by means of a diamond grinding wheel with an abrasive grain size of #100 following the completion of polishing, the surface of the window on the side of the object of polishing was scratched, and became opaque. The total amount of transmitted light passing through the window in this case was 1% or less of the total amount of transmitted light prior to dressing (i.e., when the surface of the window on the side of the object of polishing was not scratched).
A second [silicon wafer] was polished under the same polishing conditions as those described above; however, in-situ measurement of the residual film thickness on the silicon wafer was not possible.

[Comparative Example 1-2]

An IC1000/SUBA400 polishing body manufactured by Rodel Co., was used as a polishing body; an opening part was formed in one place in this polishing body. A window consisting of an acrylic [resin] was installed in the opening part of the polishing body so that the amount of recess of the surface of the window on the side of the object of polishing from the surface of the polishing body was 0.1 mm.
This polishing body was installed in a polishing apparatus of the type shown in Figure 2, and 150 six-inch silicon wafers on which a thermal oxidation film was formed to a thickness of 1 $\mu$m were continuously polished under the conditions shown be low. The residual film thickness on the silicon wafers was measured in situ.

Polishing head rpm: 50 rpm
Platen rpm: 50 rpm
Load applied to polishing head: 2.4 $\times$ 10$^4$ Pa
Oscillation of polishing head: none
Polishing time: 90 sec
Polishing agent used: SS25 manufactured by Cabot Co., diluted 2X with ion exchange water
Polishing agent flow rate: 200 ml/min
Dressing conditions: 1 minute for each silicon wafer polished, using a diamond grinding wheel with an abrasive grain size of #100

As a result, scratching of the window occurred after 17 [silicon wafers] were polished. When polishing was continued, the amount of light reflected from the silicon wafer became attenuated after 53 [wafers] were polished, so that in-situ measurement became difficult. When the window was checked, it was found that the window had come to resemble mica glass as a result of scratches caused by dressing. Measurements of the thickness of the polishing body before and after polishing indicated that the polishing body had su ffered 0.05 m of wear as a result of polishing and dressing.

[Comparative Example 1-3]

An acrylic window with a size of 20 mm $\times$ 50 mm and a thickness of 2 mm on which an anti-reflection film was formed was fastened in the same manner as in Embodiment 1-6 in the opening part of a polishing body manufactured in the same manner as in Embodiment 1-6, so that the surface of the window and the surface of the polishing body were at the same height. The recess of the surface of the window with respect to the surface of the polishing body in this case was 10 $\mu$m or less.
This polishing body was attached to a polishing apparatus of the type shown in Figure 2, and a six-inch silicon wafer on which a thermal oxidation film was formed to a thickness of 1 $\mu$m was polished under the conditions shown below. The residual film thickness of the oxidation film on the silicon wafer was measured in situ.

    Polishing head rpm: 50 rpm
    Polishing platen rpm: 50 rpm
    Load (pressure with which the object of polishing was pressed against the polishing body): $2.4 \times 10^4$ Pa
    Oscillation: none
    Polishing time: 90 sec
    Polishing agent used: SS25 manufactured by Cabot Co., diluted 2X with ion exchange water
    Polishing agent flow rate: 200 ml/min

As in Embodiments 1-5 and 1-6, a reflective spectrum from the surface of the silicon wafer was obtained by measurement in situ, and it was possible to measure the polished state (i.e., the residual film thickness of the thermal oxidation film on the surface of the silicon wafer) in situ. However, the silicon wafer was scratched by polishing.

[Comparative Example 1-4]

A polyurethane window with a size of 20 mm $\times$ 50 mm and a thickness of 2 mm was fastened in the same manner as in Embodiment 1-6 in the opening part of a polishing body manufactured in the same manner as in Embodiment 1-6, so that the surface of the window and the surface of the polishing body were at the same height.
This polishing body was attached to a polishing apparatus of the type shown in Figure 2, and a six-inch silicon wafer on which a thermal oxidation film was formed to a thickness of 1 $\mu$m was polished under the conditions shown below. The residual film thickness of [the oxidation film on] the silicon wafer was measured in situ using the opening part.

    Polishing head rpm: 50 rpm
    Polishing platen rpm: 50 rpm
    Load (pressure with which the object of polishing was pressed against the polishing body): $2.4 \times 10^4$ Pa
    Oscillation: none
    Polishing time: 90 sec
    Polishing agent used: SS25 manufactured by Cabot Co., diluted 2X with ion exchange water
    Polishing agent flow rate: 200 ml/min

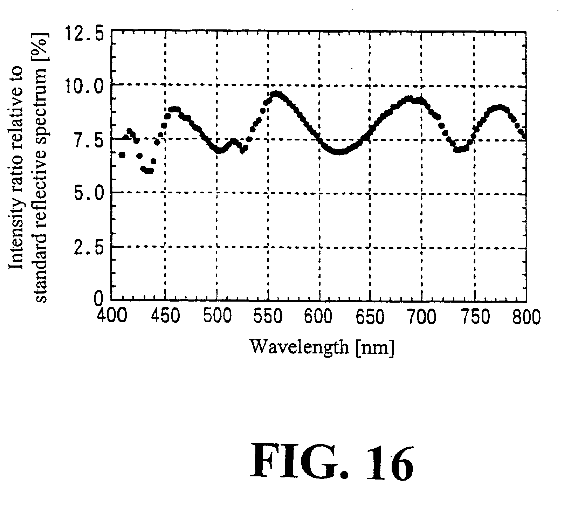

In this case, there was no scratching of the silicon wafer or non-uniform polishing caused by the window. Figure 16 is a graph of the reflective spectrum obtained in this case. As a result of deformation of the polyurethane window, the shape of the measured reflective spectrum was distorted, so that this spectrum did not agree with the measurement simulation; accordingly, film thickness measurement was difficult.

[Working Configuration 1-7]

A method for adjusting the gap between the outermost surface of the polishing pad 21 (i.e., the surface that contacts the object of polishing) and the surface of the window plate 31 on the side of the outermost surface of the polishing pad 21 in the above-mentioned polishing apparatus shown in Figure 2, this method being one example of a working configuration of the present invention, will be described. A device which measures the polished film thickness or the polishing endpoint from the reflective spectroscopic characteristics (reflective spectrum) is used as the polished-state measuring device 23. The reflective spectrum measured by the polished-state measuring device 23 is compared with a reference spectrum obtained by simulation, etc., in the signal processing device of the polished-state measuring device 23, so that the polished film thickness or polishing endpoint is measured.
In cases where the gap between [the outermost surface of the polishing body 21] and the surface of the window plate 31 on the side of the outermost surface of the polishing body 21 is too large, the loss of light caused by the polishing agent that is present in the recessed part formed in the polishing body 21 above the window plate 31 becomes excessive. As a result, only a very weak signal can be obtained in the polished-state measuring device 23, so that the polished film thickness or polishing endpoint cannot be measured in a favorable manner. On the other hand, in cases where the gap between [the outermost surface of the polishing body 21] and the surface of the window plate 31 on the side of the outermost surface of the polishing body 21 is too small, a signal created by the interference of the layer of polishing agent that is present in the above-mentioned recessed part is added to the signal of the polished-state measuring device 23, so that the polished film thickness or polishing endpoint cannot be measured in a favorable manner.
In the present working configuration, however, the gap between the outermost surf ace of the polishing body 21 (i.e., the surface that contacts the object of polishing) and the surface of the window plate 31 on the side of this outermost surface is adjusted while monitoring the signal measured by the polished-state measuring device 23 so that a signal with a strength that allows favorable measurement of the polished film thickness or polishing endpoint can be measured by the polished-state measuring device 23. Accordingly, in the polishing process, the polished-state measuring device 23 can measure the polished film thickness or polishing endpoint in a favorable manner.

[Working Configuration 1-8]

Next, a method for measuring the polished film thickness or polishing endpoint which constitutes a working configuration of the present invention will be described with reference to Figure 2. [Here,] a device which measures the polished film thickness or polishing endpoint from the reflective spectroscopic characteristics (reflective spectrum) is used as the polished-state measuring device 23.

There may be instances in which the thickness of the [layer of] polishing agent between the window plate 31 and object of polishing is not constant during polishing, so that an inappropriate signal is obtained in the measurement of the polished film thickness or polishing endpoint. The term "inappropriate signal" refers to (for example) an extremely weak signal that is obtained in cases where the loss caused by the polishing agent is excessive as described above, or a signal which includes a signal caused by interference of the layer of polishing agent that is present in the recessed part formed on top of the window plate 31.

In the present working configuration, this problem is dealt with as follows: specifically, inappropriate signals obtained during adjustment by the adjustment method constituting the [above-mentioned] working configuration of the present invention, etc., are stored in a memory device (not shown in the figures) as signals measured beforehand; then, during polishing, the present working configuration includes a stage in which the signal measured by the polished-state measuring device 23 is compared with the above-mentioned signals stored in the memory device, and if these signals are equal, the signal measured by the polished-state measuring device 23 is not used in polished film thickness [measurement] or polishing endpoint detection. As a result, even in cases where the thickness of the [layer of] polishing agent between the window and the object of polishing is not constant, so that [measurement] is unstable, there is no erroneous measurement in the measurement of the polished film thickness or polishing endpoint.

[Working Configuration 1-9]

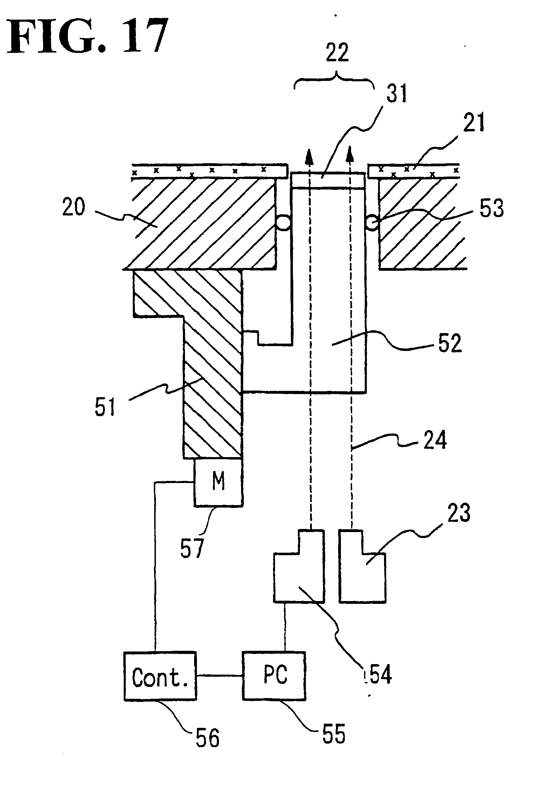

Figure 17 is a sectional view of the area in the vicinity of the opening part in the platen of a polishing apparatus constituting a working configuration of the present invention. In Figure 17, 51 indicates a moving device consisting of an electrically operated stage, 52 indicates a window supporting stand, 53 indicates an O-ring, 54 indicates a gap sensor, 55 indicates a computer, 56 indicates a stage controller, and 57 indicates a motor.

A window supporting stand 52 which supports the window plate 31 is attached to the moving device 51, and a movable window formed by installing the window plate 31 on the upper end of the window supporting stand 52 is installed in the opening part 22 of the platen 20. Thus, the window plate 31 is installed in the platen 20 via the window supporting stand 52 and the moving device 51. A piezo[-electric] stage, etc., may also be used as the moving device 51 instead of an electrically operated stage. The window supporting stand 52 is a pipe-form part, and the hollow part of this pipe forms a light path for polishing endpoint detection or film thickness measurement, etc. In order to prevent invasion by the polishing agent, the gap between the opening part 22 in the platen 20 and the window supporting stand 52 is sealed by means of grease (not shown in the figures) or an O-ring 53, or both.

The window supporting stand 52 and window plate 31 can be moved in the vertical direction in Figure 17 by means of the moving device 51, so that the position of the surface of the window plate 31 on the side of the object of polishing can be moved.

A device 23 which observes the state of the polished surface, and a gap sensor 54 which senses the gap between the surface of the window plate 31 and the polished surface of the silicon wafer constituting the object of polishing, are installed beneath the platen 20. The gap between the surface of the window plate 31 on the side of the object of polishing and the polished surface of the object of polishing is the same as the amount of recess of the surface of the window plate 31 on the side of the object of polishing with respect to the surface of the polishing body 21. Polishing endpoint detection or film thickness measurement is performed by the polished-state measuring device 23. A sensor utilizing the auto-focus principle, a sensor utilizing the interference principle, or a sensor which emits light, receives the reflected light and outputs a control signal so that the amount of light received remains constant, etc., may be used as the gap sensor 54.

The motor 57 of the electrically operated stage is driven via the computer 55 (which constitutes a control device) and stage controller 56 in accordance with the measurement results of the gap sensor 54, so that the gap between the surface of the window plate 31 on the side of the object of polishing and the polished surface of the silicon wafer (not shown in the figures) constituting the object of polishing is controlled. Furthermore, the control of the gap between the surface of the window plate 31 and the polished surface of the silicon wafer (not shown in the figures) according to the signal from the gap sensor 54 is set and controlled by the computer 55 so that the above-mentioned gap always remains constant.

Each time the polishing of one silicon wafer is completed, dressing is performed. During dressing as well, the position of the surface of the window plate 31 is controlled so that this position is fixed in the position to which the surface was controlled during the above-mentioned polishing. Following dressing, the silicon wafer that is to be polished next is attach ed to the polishing head 16, and polishing is performed. Thus, the polishing process and dressing process are alternately repeated.

Furthermore, in this working configuration, the position of the window plate 54 is controlled using a gap sensor 54 [that senses the gap] between the surface of the window plate 31 on the side of the object of polishing and the polished surface of the silicon wafer that constitutes the object of polishing; however, it would also be possible to install a device that senses the state of wear of the polishing body 21 instead of [the above-mentioned] gap sensor 54. In such a case, the moving device 51 may be controlled so that the surface of the window plate 31 on the side of the object of polishing is moved downward in Figure 17 by an amount corresponding the amount of wear of the polishing body 21.

A contact needle type displacement gauge or an optical displacement gauge, etc., can be used as a device that senses the state of wear of the polishing body 21. Furthermore, control of the position of the window plate 31 may also be performed using both a gap sensor 54 and a device that senses the state of wear of the polishing body.

Thus, in the polishing apparatus of the present working configuration, the position of the surface of the window plate 31 on the side of the object of polishing is controlled by the moving device 51, so that the surface of the window plate 31 on the side of the object of polishing is recessed with respect to the surface of the polishing body 21, thus maintaining a constant gap between the surface of the window plate 31 and the polished surface of the silicon wafer that constitutes the object of polishing, and this state is also maintained during dressing. Accordingly, since the surface of the window on the side of the object of polishing is not scratched by dressing, polishing endpoint detection or film thickness measurement can be accomplished at all times. As a result, the same polishing body can be used in polishing for a longer period of time than is possible in the case of conventional [polishing bodies], so that the frequency of replacement of the polishing body or window is reduced, thus making it possible to reduce the cost of polishing.

Furthermore, in the polishing apparatus of the present working configuration, the control of the gap between the surface of the window plate 31 and the polished surface of the silicon wafer is set and controlled by a computer 55 so that the above-mentioned gap is always maintained at a constant value; however, in a method that differs from this control method, it would also be possible to control the gap between the surface of the window and the polished surface of the silicon wafer by using the [above-mentioned] computer 55 to predict the amount of wear of the polishing body from the polishing conditions, polishing time, dressing conditions and dressing time.

In the descriptions of the respective working configurations given above, it was assumed that dressing was performed each time that the polishing of a single silicon wafer is completed; however, it goes without saying that these working configurations could also be used in cases where dressing of the polishing body is performed each time that the polishing of an appropriate number of silicon wafers consisting of two or more silicon wafers is completed.

[Working Configuration 1-10]

The basic construction of the polishing apparatus of the present working configuration is the same as the construction in Working Configuration 1-9 (Figure 17); however, a position sensor is further installed on the platen 20. The position sensor that is used is a sensor that outputs a signal only when a silicon wafer is positioned above the opening part 22 in the platen (or only when no silicon wafer is positioned above the opening part in the platen), and the above-mentioned signal from this position sensor is input into the computer 55. Furthermore, dynamic control that is synchronized with the rotation of the platen 20 is performed, thus causing the window plate 31 to be moved, so that when a silicon wafer is present in a position other than a position above the opening part 22, the amount of recess of the surface of the window plate 31 on the side of the object of polishing with respect to the surface of the polishing body 21 is increased to a value that is greater than the gap that is present between the surface of the window plate 31 and the silicon wafer when a silicon wafer is positioned above the opening part 22.

Thus, since the amount of recess of the window is controlled so that this amount of recess is small only when the polishing endpoint or film thickness is being measured during polishing, and is large at all other times, there is no need to perform dressing of the polishing body 21 between polishing operations; [instead,] a diamond grinding wheel, etc., used for dressing can be disposed on the polishing body 21 together with the polishing head, and dressing can be performed simultaneously (i.e., in situ) with polishing.

Thus, in the polishing apparatus of the present working configuration, as a result of the position of the surface of the window plate 31 on the side of the object of polishing being controlled by the moving device 51, the amount of recess of the surface of the window plate 31 on the side of the object of polishing with respect to the surface of the polishing body 21 is increased when a diamond grinding wheel used for dressing passes over the opening part of the polishing body 21; accordingly, even if dressing is performed while the object of polishing is being polished, this dressing will cause no scratching of the surface of the window on the side of the object of polishing, so that polishing endpoint detection or film thickness measurement can be performed at all times.

As a result, the same polishing body can be used in polishing for a longer period of time than is possible in the case of conventional [polishing bodies], so that the frequency of replacement of the polishing body or window is reduced; furthermore, since there is no need to take [extra] time in order to perform dressing, the overall time required for the polishing of a plurality of objects of polishing is shortened. Accordingly, the cost of polishing can be reduced.

Thus, in the above-mentioned Working Configurations 1-9 and 1-10 as well, it is desirable (for the reasons described above) that the position of the window be controlled so that the amount of recess d of the surface of the window on the side of the object of polishing with respect to the surface of the polishing body in the position where the measurement light passes through is such that $0 \ \mu m < d \leq 400 \ \mu m$.

Furthermore, in these working configurations as well, it is desirable that a material of the type described above be used as the window material.

[Working Configuration 1-11]

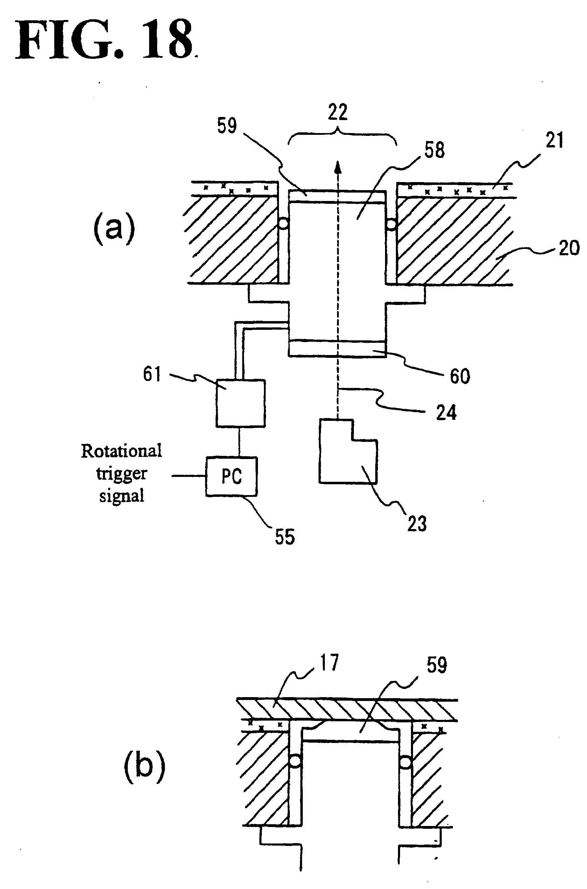

Figure 18 shows a schematic outline of the area in the vicinity of the polishing body of the polishing apparatus of the present working configuration. Figure 18 (a) is a sectional view of the area in the vicinity of the opening part, and Figure 18 (b) is a sectional view which shows the conditions in the vicinity of the opening part when the object of polishing has arrived at a point above the opening part. In Figure 18, 58 indicates a window fastening tube, 59 indicates a transparent rubber window, 60 indicates a glass window, and 61 indicates an air pressure control device.

A transparent rubber window 59 is attached to the upper end of the window fastening tube 58, and a glass window 60 is attached to the lower end. Furthermore, an air pressure control device 61 which is used to pressurize or depressurize the interior of the window fastening tube 58 is connected to the window fastening tube 58. A polishing body 21 in which an opening part that conforms to the size of the transparent rubber window 59 is formed is installed by being bonded to the platen 20. The transparent rubber window 59 is installed in the platen 20 via the window fastening tube 58, which functions as a moving device.

When the pressure inside the window fastening tube 58 is a reduced pressure (ordinary pressure), the window fastening tube 58 is disposed in the opening part 22 of the platen 20 in a position which is such that the surface of the transparent rubber window 59 on the side of the object of polishing is recessed with respect to the surface of the polishing body 21. Then, when the pressure inside the window fastening tube 58 is increased by the air pressure control device 61, the transparent rubber window 59 attached to the upper end of the window fastening tube 58 expands upward.

When the transparent rubber window 59 expands upward, this window tends to protrude slightly upward from the surface of the polishing body 21; however, when a silicon wafer 17 is present above the opening part 22, the surface of the transparent rubber window 59 on the side of the object of polishing adheres tightly to the polished surface of the silicon wafer 59 as shown in Figure 18 (b).

Thus, by adjusting the pressure inside the window fastening tube 58 by means of th e air pressure control device 61, it is possible to cause expansion of the transparent rubber window 59, so that [this device] functions as a moving device that moves the surface of the transparent rubber window 59 on the side of the object of polishing up ward and downward in Figure 18.

A position sensor is installed on the platen 20; the position sensor used in this case is a sensor that outputs a signal only when a silicon wafer 17 is positioned above the opening part 22 in the platen (or only when no silicon wafer is positioned above the opening part in the platen), and the above-mentioned signal from this position sensor is input into the computer 55. Furthermore, dynamic control that is synchronized with the rotation of the platen 20 is performed so that when a silicon wafer 17 is positioned above the opening part 22, the pressure inside the window fastening tube 58 is increased, and so that when such a wafer is positioned in any other position, the pressure inside the window fastening tube 58 is reduced (to ordinary pressure). As a result of this control, the surface of the transparent rubber window 59 on the side of the object of polishing contacts the surface of the silicon wafer 17 when such a silicon wafer 17 is present above the opening part 22, and the surface of the transparent rubber window 59 on the side of the object of polishing is recessed with respect to the surface of the polishing body 21 when such a wafer is present in any other position.

A polished-state measuring device 23 is installed beneath the platen 20, and polishing endpoint detection and film thickness measurement are performed in the same manner as in Working Configuration 1-9.

As a result of the position of the surface of the transparent rubber window 59 being controlled as described above, there is no need to perform dressing of the polishing body 21 between polishing operations; instead, in-situ dressing is possible.

Furthermore, [this working configuration] is arranged so that the surface of the transparent rubber window 59 on the side of the object of polishing contacts the silicon wafer 17 during polishing endpoint detection or film thickness measurement; however, such contact is not absolutely necessary.

In the present working configuration as well, for the reasons described above, it is desirable that the amount of recess d of the portion of the transparent rubber window 59 through which the light from the polished-state measuring device 23 passes (i.e., the portion that is used for polishing endpoint detection and film thickness measurement) be such that $0 \ \mu m < d \leq 400 \ \mu m$ during measurement, and an amount of recess which is such that $10 \ \mu m < d \ s \ 200 \ \mu m$ is especially desirable.

Thus, in the polishing apparatus of the present working configuration, the position of the surface of the window on the side of the object of polishing is controlled by controlling the pressure inside the window fastening tube 58, so that the amount of recess of the surface of the window on the side of the object of polishing with respect to the surface of the polishing body is increased when the diamond grinding wheel used for dressing passes over the opening part of the polishing body. Accordingly, even if dressing is performed while the object of polishing is being polished, this dressing causes no scratching of the surface of the window on the side of the object of polishing, so that polishing endpoint detection or film thickness measurement can be accomplished at all times. As a result, the same polishing body can be used in polishing for a longer period of time than is possible in the case of conventional [polishing bodies], so that the frequency of replacement of the polishing body or window is reduced; furthermore, since there is no need to take [extra] time in order to perform dressing, the overall time required for the polishing of a large number of objects of polishing is shortened. Accordingly, the cost of polishing can be reduced.

In all of the working configurations described above, it is desirable to use a device that detects the polishing endpoint and measures the film thickness from the reflective spectroscopic characteristics (i.e., the reflective spectrum) as the polished-state measuring device 23 that is installed beneath the platen 20. Calculation of the film thickness or detection of the polishing endpoint is accomplished by comparing the reflective spectrum measured by the polished-state measuring device 23 with a reference spectrum obtained by simulation, etc., in a computer (not shown in the figures). Furthermore, it would also be possible to use a device that detects the polishing endpoint or measures the film thickness from variations in the reflectivity at a specified wavelength, or a device that detects the polishing endpoint or measures the film thickness by imaging the polished surface with a CCD camera, etc., and subjecting the image thus acquired to image processing, etc., as the polished-state measuring device 23 instead of the above-mentioned device that detects the polishing endpoint and measures the film thickness from the reflective spectroscopic characteristics (reflective spectrum).

[Embodiment 1-7]

A polishing apparatus with a construction such as that shown in Figure 17 was manufactured. A window supporting stand 52 was attached to a moving device (electrically operated stage) 51 that had a stroke of 10 mm, and an acrylic window plate 31 was installed on the upper end of this window supporting stand 52.

A polished-state measuring device 23 and a gap sensor 54 were installed beneath the platen 20. A sensor utilizing an auto-focus mechanism was used as the gap sensor 54.

Next, a polishing body 21 (IC1000/SUBA400 manufactured by Rodel Co.) in which an opening part conforming to the size of the window plate 31 was formed was installed on the platen 20. The control of the gap of the window plate 31 by means of a signal from the gap sensor 54 was set so that the gap between the surface of the window plate 31 on the side of the object of polishing and the polished surface of the silicon wafer was constantly controlled to 0.2 mm.

Subsequently, 150 six-inch silicon wafers on which a thermal oxidation film was formed to a thickness of 1 μm were consecutively polished one wafer at a time under the conditions shown below, and the residual film thickness on the silicon wafers was measured in situ by means of the polished-state measuring device 23.

Polishing head rpm: 50 rpm
Platen rpm: 50 rpm
Load applied to polishing head: $2.4 \times 10^4$ Pa
Oscillation of polishing head: none
Polishing time: 90 sec
Polishing agent used: SS25 manufactured by Cabot Co., diluted 2X with ion exchange water
Polishing agent flow rate: 200 ml/min

After the completion of polishing, dressing was performed for 1 minute using a diamond grinding wheel with an abrasive grain size of #100.

As a result, [it was found] from measurements of the thickness of the polishing body before and after polishing that the polishing body 21 showed 0.17 mm of wear as a result of polishing and dressing. However, there was no scratching of the window plate 31.

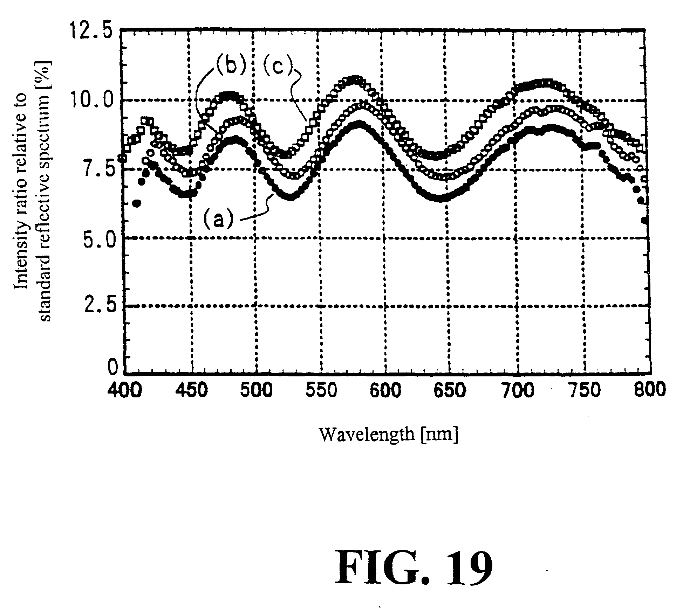

Figure 19 is a graph of the reflective spectra from the surfaces of the silicon wafers that were measured in situ at a certain instant during polishing. In the graph shown in Figure 19, the horizontal axis indicates wavelength, while the vertical axis indicates the intensity ratio of the measured reflective spectrum to a standard reflective spectrum obtained in a case where a silicon wafer on which an aluminum film had been formed was installed on top of the window part of the polishing body in a state in which ion exchange water was interposed instead of the polishing agent, with the reflective spectrum of the light returning to the polished-state measuring device 23 being taken as the [above-mentioned] standard reflective spectrum. In the polishing of all of the 150 silicon wafers, reflective spectra such as that indicated by curve (a) in Figure 19 were obtained at a certain instant at which the same time had elapsed from the initiation of polishing; thus, favorable in-situ measurement was accomplished.

[Embodiment 1-8]

Using the same apparatus as in Embodiment 1-7 (Figure 17), polishing was performed using the method of Working Configuration 2-4. Control was performed so that the gap between the surface of the window on the side of the object of polishing and the polished surface of the above-mentioned object of polishing was 0.1 mm when the window plate 31 was positioned beneath the silicon wafer, and so that the gap between the surface of the window on the side of the object of polishing and the polished surface of the above-mentioned object of polishing was 0.5 mm when [the window plate 31] was positioned in other positions.

Subsequently, 150 six-inch silicon wafers on which a thermal oxidation film was formed to a thickness of 1 μm were consecutively polished one wafer at a time under the conditions shown below, and the residual film thickness on the silicon wafers was measured in situ by means of the polished-state measuring device 23.

Polishing head rpm: 50 rpm
Platen rpm: 50 rpm
Load applied to polishing head: $2.4 \times 10^4$ Pa
Oscillation of polishing head: none
Polishing time: 90 sec
Polishing agent used: SS25 manufactured by Cabot
Co., diluted 2X with ion exchange water
Polishing agent flow rate: 200 ml/min
Dressing conditions: 1 minute for each silicon wafer
polished, using a diamond grinding wheel with an
abrasive grain size of #100

As a result, [it was found] from measurements of the thickness of the polishing body before and after polishing that the polishing body 21 showed 0.15 mm of wear as a result of polishing and dressing. However, there was no scratching of the window plate 31. Furthermore, in the polishing of all of the 150 silicon wafers, reflective spectra such as that indicated by curve (b) in Figure 19 were obtained at a certain instant at which the same time had elapsed from the initiation of polishing; thus, favorable in-situ measurement was accomplished.

[Embodiment 1-9]

A polishing apparatus with a construction of the type shown in Figure 18 was manufactured. A transparent rubber window 59 with a thickness of 0.2 mm was attached to the upper end of the window fastening tube 58, and a glass window 60 was attached to the lower end.
A polishing body 21 (IC1000/SUBA400 manufactured by Rodel Co.) in which an opening part conforming to the size of the transparent rubber window 59 was formed was bonded to the platen 20; then, the window fastening tube 58 was installed in the opening part 22 of the platen 20 so that the gap from the surface of the transparent rubber window 59 on the side of the object of polishing to the surface of the polishing body 20 under reduced pressure (ordinary pressure) was 0.6 mm.
[The apparatus] was set so that the pressure inside the window fastening tube 58 was increased when a silicon wafer 17 was present above the opening part 22, thus causing the surface of the transparent rubber window 59 on the side of the object of polishing to adhere tightly to the polished surface of the silicon wafer 17.
Subsequently, 150 six-inch silicon wafers on which a thermal oxidation film was formed to a thickness of 1 $\mu$m were consecutively polished one wafer at a time under the conditions shown below, and the residual film thickness on the silicon wafers was measured in situ by means of the polished-state measuring device 23.

Polishing head rpm: 50 rpm
Platen rpm: 50 rpm ,
Load applied to polishing head: $2.4 \times 10^4$ Pa
Oscillation of polishing head: none
Polishing time: 90 sec
Polishing agent used: SS25 manufactured by Cabot Co., diluted 2X with ion exchange water
Polishing agent flow rate: 200 ml/min
Dressing conditions: 1 minute for each silicon wafer
polished, using a diamond grinding wheel with an
abrasive grain size of #100

As a result, [it was found] from measurements of the thickness of the polishing body before and after polishing that the polishing body showed 0.16 mm of wear as a result of polishing and dressing. However, there was no scratching of the window 72. Furthermore, in the polishing of all of the 150 silicon wafers, reflective spectra such as that indicated by curve (c) in Figure 19 were obtained at a certain instant at which the same time had elapsed from the initiation of polishing; thus, favorable in-situ measurement was accomplished.
Below, an example of a working configuration relating to the invention that is used to achieve the second object of the present invention will be described.

[Working Configuration 2-1]

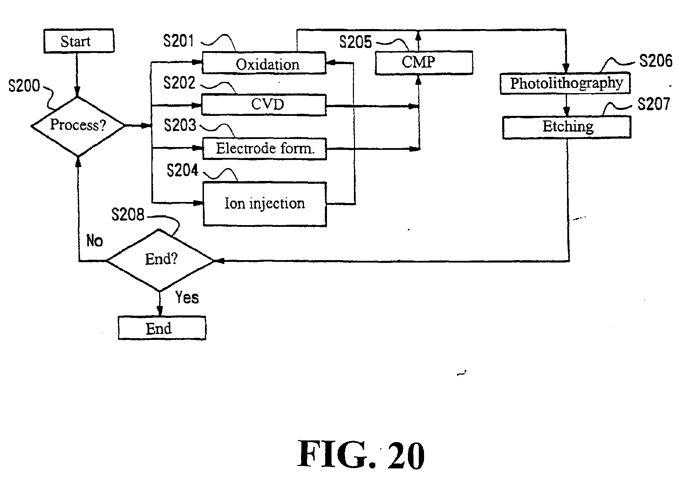

Figure 20 is a flow chart which illustrates the semiconductor device manufacturing process [of the present invention]. When the semiconductor device manufacturing process is started, an appropriate working process is first selected in step S200 from steps S201 through S204 described below. The processing then proceeds to one of the steps S201 through S204 in accordance with this selection.
Step S201 is an oxidation process in which the surface of the silicon wafer is oxidized. Step S202 is a CVD process in which an insulating film is formed on the surface of the silicon wafer by CVD, etc. Step S203 is an electrode formation process in which electrodes are formed on the silicon wafer by a process such as vacuum evaporation, etc. Step S204 is an ion injection process in which ions are injected into the silicon wafer.
Following the CVD process or electrode formation process, the work proceeds to step S205. Step S205 is a CMP process. In this CMP process, the smoothing of inter-layer insulation films or the formation of a damascene by the polishing of metal films on the surfaces of semiconductor devices, etc., is performed using the polishing apparatus of the present invention.
Following the CMP process or oxidation process, the work proceeds to step S206. Step S206 is a photolithographic process. In this photolithographic process, the silicon wafer is coated with a resist, a circuit pattern is burned onto the silicon wafer by exposure using an exposure apparatus, and the exposed wafer is developed. Furthermore, the next step S207 is an etching process in which the portions other than the developed resist image are removed by etching, and the resist is then stripped away, so that the resist that is unnecessary when etching is completed is removed.
Next, in step S208, a judgement is made as to whether or not all of the necessary processes have been completed; if these processes have not been completed, the work returns to step S200, and the previous steps are repeated so that a circuit pattern is formed on the silicon wafer. If it is judged in step S208 that all of the processes have been completed, the work is ended.

Since the [polishing] apparatus and [polishing] method of the present invention are used in the CMP process in the semiconductor device manufacturing method of the present invention, the precision of polishing endpoint detection or the precision of film thickness measurement in the CMP process can be improved, so that the yield of the CMP process is improved. As a result, semiconductor devices can be manufactured at a lower cost than in conventional semiconductor device manufacturing methods.

Furthermore, the polishing apparatus of the present invention can also be used in the CMP processes of semiconductor device manufacturing processes other than the above-mentioned semiconductor device manufacturing process.

Possibilities for Industrial Utilization

As was described above, the present invention can be used as the apparatus and method employed in the CMP process of a semiconductor manufacturing process. As a result, the precision of polishing endpoint detection or the precision of film thickness measurement in the CMP process can be improved, so that the yield of the CMP process is improved. Accordingly, semiconductor devices can be manufactured at a lower cost than in conventional semiconductor device manufacturing methods.

Furthermore, in the description of the present invention, the polishing of wafers on which a pattern was formed as shown in Figure 1 was described as an example; however, it goes without saying that the present invention can also be used for other purposes such as polishing for the purpose of smoothing bare silicon wafers, etc.

**Claims**

1. A polishing body (21) used in a polishing apparatus which is equipped with a polishing head (16) that holds the object of polishing (17) and the polishing body (21), and which polishes the above-mentioned object of polishing (17) by causing relative motion between the above-mentioned polishing body (21) and the above-mentioned object of polishing (17) in a state in which a polishing agent is interposed between the above-mentioned polishing body (21) and the above-mentioned object of polishing (17); wherein one or more opening parts (32, 32a-32c) which are used to allow the passage of measurement light that optically measures the surface that is being polished on the above-mentioned object of polishing (17) are formed in the above-mentioned polishing body (21), and wherein a window plate (31, 31a-31c) that is transparent to at least the measurement light is fit into each of the above-mentioned one or more opening parts (32, 32a-32c), and wherein the surface of the respective window plate (31, 31a-31c) on the side of the above-mentioned object of polishing (17) is recessed with respect to the surface of the above-mentioned polishing body (21) **characterized in that** the amount of this recess being varied in a stepwise or continuous manner.

2. The polishing body (21) claimed in Claim 1, which is **characterized by** the fact that the polishing body (21) has a plurality of the above-mentioned opening parts (32, 32a-32c), and that the above-mentioned amount of recess varies in a stepwise manner as a result of this amount of recess being different in each of the above-mentioned opening parts (32, 32a-32c).

3. The polishing body (21) claimed in Claim 1, which is **characterized by** the fact that the above-mentioned amount of recess varies in a stepwise manner as a result of this amount of recess being different in two or more portions within the same opening part (32, 32a-32c).

4. The polishing body (21) claimed in Claim 1, which is **characterized by** the fact that the respective window plate (31, 31a-31c) is a parallel flat-plate-form transparent plate, and that the respective window plate (31, 31a-31c) is installed at an inclination with respect to the surface of the above-mentioned polishing body (21), so that the above-mentioned amount of recess varies in a continuous manner.

5. A polishing body (21) used in a polishing apparatus which is equipped with a polishing head (16) that holds the object of polishing (17) and the polishing body (21), and which polishes the above-mentioned object of polishing (17) by causing relative motion between the above-mentioned polishing body (21) and the above-mentioned object of polishing (17) in a state in which a polishing agent is interposed between the above-mentioned polishing body (21) and the above-mentioned object of polishing (17); wherein one or more opening parts (32, 32a-32c) which are used to allow the passage of measurement light that optically measures the surface that is being polished on the above-mentioned object of polishing (17) are formed in the above-mentioned polishing body (21), and wherein a window plate (31, 31a-31c) that is transparent to at least the measurement light is fit into each of the above-mentioned one or more opening parts (32, 32a-32c), and wherein the surface of the respective window plate (31, 31a-31c) on the side of the above-mentioned object of polishing (17) is recessed with respect to the surface of the above-mentioned polishing body (21), **characterized in that** the respective window plate (31, 31a-31c) is constructed from a plate material consisting of a plurality of sheets of a transparent material (35a-35d) that can be stripped away.

6. The polishing body (21) claimed in any of Claims 1 through 5, which is **characterized by** the fact that a minimum amount d of the recess between the outermost surface of the above-mentioned polishing body (21) and the surface of the respective window plate (31, 31a-31c) on the side of the above-mentioned outermost surface is such that $0 \ \mu m < d \leq 400 \ \mu m$.

7. The polishing body (21) claimed in any of Claims 1 through 5, which is **characterized by** the fact that a minimum amount d of the recess between the outermost surface of the above-mentioned polishing body (21) and the surface of the respective window plate (31, 31a-31c) on the side of the above-mentioned outermost surface is such that $10 \ \mu m < d \leq 200 \ \mu m$.

8. The polishing body (21) claimed in any of Claims 1 through 5, which is **characterized by** the fact that a maximum amount d of the recess between the outermost surface of the above-mentioned polishing body (21) and the surface of the respective window plate (31, 31a-31c) on the side of the above-mentioned outermost surface is such that $0 \ \mu m < d \leq$ 90% of the thickness of the polishing body (21), and that the thickness t of the respective window plate (31, 31a-31c) is such that $t \geq 10\%$ of the thickness of the polishing body (21).

9. The polishing body (21) claimed in any of Claims 1 through 8, which is **characterized by** the fact that at least the surface of the respective window plate (31, 31a-31c) located on the side of the object of polishing (17) is coated with a hard coating.

10. The polishing body (21) claimed in any of Claims 1 through 9, which is **characterized by** the fact that the transmissivity of the respective window plate (31, 31a-31c) with respect to the measurement light is 22% or greater.

11. A polishing apparatus which is equipped with a polishing head (16) that holds the object of polishing (17) and a polishing body (21), and which polishes the above-mentioned object of polishing (17) by causing relative motion between the above-mentioned polishing body (21) and the above-mentioned object of polishing (17) in a state in which a polishing agent is interposed between the above-mentioned polishing body (21) and the above-mentioned object of polishing (17), the above-mentioned polishing body (21) being the polishing body (21) claimed in any one of Claims 1 through 10.

12. The polishing apparatus claimed in Claim 11, which is **characterized by** the fact that the apparatus has a function in which measurement light is directed onto the object of polishing (17) from a light-projecting device via the respective window plate (31, 31a-31c) and the above-mentioned opening parts (32, 32a-32c), this light is reflected by the object of polishing (17), and the returning light that again passes through the above-mentioned opening parts (32, 32a-32c) and the respective window plate (31, 31a-31c) is received by a light-receiving device, wherein the intensity of the light that is received during the polishing operation is 1% or more of the intensity of the projected light.

13. The polishing apparatus claimed in Claim 11 or Claim 12, which is **characterized by** the fact that the respective window plate (31, 31a-31c) consists of a resin that has polishing characteristics comparable to the polishing characteristics of the above-mentioned polishing body (21).

14. A method for measuring the thickness of a polished film or the endpoint of polishing in which polishing is performed using the polishing apparatus claimed in any one of Claims 11 through 13, and the thickness of the polished film or endpoint of polishing is measured using a light signal received by a light-receiving device; wherein the signal measured by the measurement means that is used to measure the polished film thickness or polishing endpoint is not used in the measurement of the polished film thickness or polishing endpoint in cases where the signal measured by the above-mentioned measurement means is equal to a signal that is measured beforehand and stored in memory.

**Patentansprüche**

1. Polierkörper (21), welcher in einer Poliervorrichtung verwendet wird, die mit einem Polierkopf (16), der den Poliergegenstand (17) hält, und dem Polierkörper (21) ausgerüstet ist, und der den Poliergegenstand (17) poliert mittels Verursachens einer relativen Bewegung zwischen dem Polierkörper (21) und dem Poliergegenstand (17) in einem Zustand, in dem ein Poliermittel zwischen den Polierkörper (21) und den Poliergegenstand (17) gebracht ist, wobei ein oder mehrere Öffnungsabschnitte (32, 32a-32c) in dem Polierkörper (21) geformt sind, welche verwendet werden, um den Durchtritt von Messlicht zu ermöglichen, welches die Oberfläche, die an dem Poliergegenstand (17) poliert wird, optisch misst, und wobei eine Fensterplatte (31, 31a-31c), welche zumindest bezüglich des Messlichts transparent ist, in jeden von dem einen oder den mehreren Öffnungsabschnitten (32, 32a-32c) eingebracht ist, und wobei die Oberfläche der jeweiligen Fensterplatte (31, 31a-31c) auf der Seite des Poliergegenstands (17) bezüglich der Oberfläche des Polierkörpers (21) vertieft ist, **dadurch gekennzeichnet, dass** der Betrag dieser Vertiefung in einer schrittweisen oder kontinuierlichen Art variiert ist.

2. Polierkörper (21) nach Anspruch 1, der **dadurch gekennzeichnet ist, dass** der Polierkörper (21) eine Mehrzahl von den Öffnungsabschnitten (32, 32a-32c) aufweist, und dass der Betrag der Vertiefung in einer schrittweisen Art variiert als ein Resultat davon, dass dieser Betrag der Vertiefung in jedem der Öffnungsabschnitte (32, 32a-32c) unterschiedlich ist.

3. Polierkörper (21) nach Anspruch 1, der **dadurch gekennzeichnet ist, dass** der Betrag der Vertiefung in einer schrittweisen Art variiert als ein Resultat davon, dass dieser Betrag der Vertiefung in zwei oder mehreren Abschnitten innerhalb desselben Öffnungsabschnitts (32, 32a-32c) unterschiedlich ist.

4. Polierkörper (21) nach Anspruch 1, der **dadurch gekennzeichnet ist, dass** die jeweilige Fensterplatte (31, 31a-31c) eine parallele flachplattenförmige transparente Platte ist, und dass die jeweilige Fensterplatte (31, 31a-31c) mit einer Neigung bezüglich der Oberfläche des Polierkörpers (21) installiert ist, so dass der Betrag der Vertiefung in einer kontinuierlichen Art variiert.

5. Polierkörper (21), der in einer Poliervorrichtung verwendet wird, welche ausgerüstet ist mit einem Polierkopf (16), der den Poliergegenstand (17) hält, und dem Polierkörper (21), und der den Poliergegenstand (17) poliert mittels Verursachens einer relativen Bewegung zwischen dem Polierkörper (21) und dem Poliergegenstand (17) in einem Zustand, in dem ein Poliermittel zwischen den Polierkörper (21) und den Poliergegenstand (17) gebracht ist, wobei ein oder mehrere Öffnungsabschnitte (32, 32a-32c) in dem Polierkörper (21) geformt sind, welche dazu verwendet werden, um den Durchtritt von Messlicht zu ermöglichen, welches die Oberfläche optisch misst, die an dem Poliergegenstand (17) poliert wird, und wobei eine Fensterplatte (31, 31a-31c), welche zumindest bezüglich des Messlichts transparent ist, in jeden von dem einen oder den mehreren Öffnungsabschnitten (32, 32a-32c) eingebracht ist, und wobei die Oberfläche der jeweiligen Fensterplatte (31, 31a-31c) auf der Seite des Poliergegenstands (17) bezüglich der Oberfläche des Polierkörpers (21) vertieft ist, **dadurch gekennzeichnet, dass** die jeweilige Fensterplatte (31, 31a-31c) aus einem Plattenmaterial aufgebaut ist, welches aus einer Mehrzahl von Lagen aus einem transparenten Material (35a-35d) besteht, welche abgestreift werden können.

6. Polierkörper (21) nach einem der Ansprüche 1 bis 5, der **dadurch gekennzeichnet ist, dass** der Minimalbetrag d der Vertiefung zwischen der äußersten Oberfläche des Polierkörpers (21) und der Oberfläche der jeweiligen Fensterplatte (31, 31a-31c) auf der Seite der äußersten Oberfläche derart ist, dass $0\ \mu m < d \leq 400\ \mu m$.

7. Polierkörper (21) nach einem der Ansprüche 1 bis 5, der **dadurch gekennzeichnet ist, dass** der Minimalbetrag d der Vertiefung zwischen der äußersten Oberfläche des Polierkörpers (21) und der Oberfläche der jeweiligen Fensterplatte (31, 31a-31c) auf der Seite der äußersten Oberfläche derart ist, dass $10\ \mu m < d \leq 200\ \mu m$.

8. Polierkörper (21) nach einem der Ansprüche 1 bis 5, der **dadurch gekennzeichnet ist, dass** der Maximalbetrag d der Vertiefung zwischen der äußersten Oberfläche des Polierkörpers (21) und der Oberfläche der jeweiligen Fensterplatte (31, 31a-31c) auf der Seite der äußersten Oberfläche derart ist, dass $0\ \mu m < d \leq 90\%$ der Dicke des Polierkörpers (21), und dass die Dicke t der jeweiligen Fensterplatte (31, 31a-31c) derart ist, dass $t \geq 10\%$ der Dicke des Polierkörpers (21).

9. Polierkörper (21) nach einem der Ansprüche 1 bis 8, der **dadurch gekennzeichnet ist, dass** zumindest diejenige Oberfläche der jeweiligen Fensterplatte (31, 31a-31c) mit einem harten Überzug beschichtet ist, die auf der Seite des Poliergegenstands (17) angeordnet ist.

10. Polierkörper (21) nach einem der Ansprüche 1 bis 9, der **dadurch gekennzeichnet ist, dass** die Transmissivität der jeweiligen Fensterplatte (31, 31a-31c) bezüglich des Messlichts 22% oder größer ist.

11. Poliervorrichtung, die mit einem Polierkopf (16), der den Poliergegenstand (17) hält, und einem Polierkörper (21) ausgerüstet ist, und die den Poliergegenstand (17) poliert mittels Verursachens einer relativen Bewegung zwischen dem Polierkörper (21) und dem Poliergegenstand (17) in einem Zustand, in dem ein Poliermittel zwischen den Polierkörper (21) und den Poliergegenstand (17) gebracht ist, wobei der Polierkörper (21) der Polierkörper (21) nach einem der Ansprüche 1 bis 10 ist.

12. Poliervorrichtung nach Anspruch 11, die **dadurch gekennzeichnet ist, dass** die Vorrichtung eine Funktion hat, in der Messlicht von einer lichtprojizierenden Vorrichtung über die jeweilige Fensterplatte (31, 31a-31c) und die Öffnungsabschnitte (32, 32a-32c) auf den Poliergegenstand (17) gerichtet wird, dieses Licht durch den Poliergegenstand (17) reflektiert wird und das zurückkehrende Licht, welches erneut durch die Öffnungsabschnitte (32, 32a-32c) und die jeweilige Fensterplatte (31, 31a-31c) durchtritt, von einer lichtaufnehmenden Vorrichtung aufgenommen wird, wobei die Intensität des Lichts, welches während des Polierbetriebs aufgenommen wird, 1% oder mehr von der Intensität des projizierten Lichts ist.

13. Poliervorrichtung nach Anspruch 11 oder Anspruch 12, die **dadurch gekennzeichnet ist, dass** die jeweilige Fensterplatte (31, 31a-31c) aus einem Harz besteht, welches Poliereigenschaften hat, welche vergleichbar sind mit den Poliereigenschaften des Polierkörpers (21).

14. Verfahren zum Messen der Dicke eines polierten Films oder des Endpunkts des Polierens, bei dem das Polieren unter der Verwendung der Poliervorrichtung nach einem der Ansprüche 11 bis 13 durchgeführt wird und die Dicke des polierten Films oder der Endpunkt des Polierens unter der Verwendung eines Lichtsignals gemessen wird, das von einer lichtaufnehmenden Vorrichtung aufgenommen wird, wobei das von dem Messmittel gemessene Signal, welches verwendet wird, um die Dikke des polierten Films oder den Polierendpunkt zu messen, in Fällen, in denen das durch das Messmittel gemessene Signal gleich einem Signal ist, das im Voraus gemessen und in einem Speicher gespeichert wurde, nicht bei der Messung der Dicke des polierten Films oder des Polierendpunkts verwendet wird.

## Revendications

1. Corps de polissage (21) utilisé dans un appareil de polissage équipé d'un touret à polir (16) maintenant l'objet à polir (17) et le corps de polissage (21), polissant l'objet à polir susmentionné (17) en provoquant un mouvement relatif entre le corps de polissage susmentionné (21) et l'objet à polir susmentionné (17) dans une configuration où un agent de polissage est interposé entre le corps de polissage susmentionné (21) et l'objet à polir susmentionné (17) ; dans lequel une ou plusieurs parties d'ouvertures (32, 32a-32c) servant à laisser passer une lumière de mesure qui mesure optiquement la surface en cours de polissage de l'objet à polir susmentionné (17) sont aménagées dans le corps de polissage susmentionné (21) et dans lequel une plaque de fenêtre (31, 31a-31c), transparente au moins à la lumière de mesure, est ajustée dans chacune de l'une ou plusieurs des parties d'ouvertures susmentionnées (32, 32a-32c), et dans lequel la surface de la plaque de fenêtre respective (31, 31a-31c) du côté de l'objet à polir susmentionné (17) est en retrait par rapport à la surface du corps de polissage susmentionné (21), **caractérisé en ce que** la dimension de cet évidement varie par paliers ou de manière continue.

2. Corps de polissage (21) selon la Revendication 1, **caractérisé en ce que** le corps de polissage (21) possède une pluralité des parties d'ouvertures susmentionnées (32, 32a-32c) et que la dimension d'évidement susmentionnée varie par paliers du fait de la différence de cette dimension d'évidement dans chacune des parties d'ouvertures susmentionnées (32, 32a-32c).

3. Corps de polissage (21) selon la Revendication 1, **caractérisé en ce que** la dimension d'évidement susmentionnée varie par paliers du fait de la différence de cette dimension d'évidement dans deux ou plusieurs parties de la même partie d'ouverture (32, 32a-32c).

4. Corps de polissage (21) selon la Revendication 1, **caractérisé en ce que** la plaque de fenêtre respective (31, 31 a-31 c) est une plaque transparente en forme de plaque plane, et que la plaque de fenêtre respective (31, 31a-31c) est installée en inclinaison par rapport à la surface du corps de polissage susmentionné (21) de manière à ce que la dimension d'évidement susmentionnée varie de manière continue.

5. Corps de polissage (21) utilisé dans un appareil de polissage équipé d'un touret à polir (16) maintenant l'objet à polir (17) et le corps de polissage (21), polissant l'objet à polir susmentionné (17) en provoquant un mouvement relatif entre le corps de polissage susmentionné (21) et l'objet à polir susmentionné (17) dans une configuration selon laquelle un agent de polissage est interposé entre le corps de polissage susmentionné (21) et l'objet à polir susmentionné (17) ; dans lequel une ou plusieurs parties d'ouvertures (32, 32a-32c) utilisées pour permettre le passage de la lumière de mesure mesurant optiquement la surface en cours de polissage sur l'objet à polir susmentionné (17) sont aménagées dans le corps de polissage susmentionné (21) et dans lequel une plaque de fenêtre (31, 31a-31c), transparente au moins à la lumière de mesure, est ajustée dans chacune de l'une ou de plusieurs des parties d'ouvertures susmentionnées (32, 32a-32c), et dans lequel la surface de la plaque de fenêtre respective (31, 31a-31c) du côté de l'objet à polir susmentionné (17) est en retrait par rapport à la surface du corps de polissage susmentionné (21) **caractérisé en ce que** la plaque de fenêtre respective (31, 31 a-31 c) est confectionnée à partir d'un matériau plaqué constitué de plusieurs feuilles de matière transparente (35a-35d) pouvant être enlevées.

6. Corps de polissage (21) selon l'une quelconque des Revendications 1 à 5, **caractérisé en ce qu'**une dimension minimum de l'évidement entre la surface la plus externe du corps de polissage susmentionné (21) et la surface de la plaque de fenêtre respective (31, 31a-31c) du côté de la surface la plus externe susmentionnée est telle que $0\ \mu m < d \leq 400\ \mu m$.

7. Corps de polissage (21) selon l'une quelconque des Revendications 1 à 5, **caractérisé en ce qu'**une dimension minimum de l'évidement entre la surface la plus externe du corps de polissage susmentionné (21) et la surface de la plaque de fenêtre respective (31, 31 a-31 c) du côté de la surface extérieure susmentionnée soit telle que $10\ \mu m < d \leq 200\ \mu m$.

8. Corps de polissage (21) selon l'une quelconque des Revendications 1 à 5, **caractérisé en ce qu'**une dimension maximum de l'évidement entre la surface la plus externe du corps de polissage susmentionné (21) et la surface de la plaque de fenêtre respective (31, 31 a-31 c) du côté de la surface la plus externe susmentionnée est telle que $0\ \mu m < d \leq 90\ \%$ de l'épaisseur du corps de polissage (21), et que l'épaisseur t de la plaque de fenêtre respective (31, 31 a-31 c) est telle que $t \geq 10\ \%$ de l'épaisseur du corps de polissage (21).

9. Corps de polissage (21) selon l'une quelconque des Revendications 1 à 8, **caractérisé en ce qu'**au moins la surface de la plaque de fenêtre respective (31, 31a-31c) située du côté de l'objet à polir (17) est revêtue d'un revêtement dur.

10. Corps de polissage (21) selon l'une quelconque des Revendications 1 à 9, **caractérisé en ce que** la transmissivité de la plaque de fenêtre respective (31, 31a-31c) est égale ou supérieure à 22 % par rapport à la lumière de mesure.

11. Appareil de polissage équipé d'un touret à polir (16) maintenant l'objet à polir (17) et un corps de polissage (21), polissant l'objet à polir susmentionné (17) en provoquant un mouvement relatif entre le corps de polissage susmentionné (21) et l'objet à polir susmentionné (17) dans une configuration où un agent de polissage est interposé entre le corps de polissage susmentionné (21) et l'objet à polir susmentionné (17), le corps de polissage susmentionné (21) étant le corps de polissage (21) revendiqué dans l'une quelconque des Revendications 1 à 10.

12. Appareil de polissage selon la Revendication 11, **caractérisé en ce que** l'appareil possède une fonction dans laquelle la lumière de mesure est dirigée sur l'objet à polir (17) à partir d'un dispositif de projection de lumière à travers la plaque de fenêtre respective (31, 31a-31c) et des parties d'ouvertures susmentionnées (32, 32a-32c), cette lumière est réfléchie par l'objet à polir (17) et la lumière réfléchie qui repasse à travers les parties d'ouvertures susmentionnées (32, 32a-32c) et la plaque de fenêtre respective (31, 31a-31c) est reçue par un dispositif récepteur de lumière dans lequel l'intensité de la lumière reçue pendant l'opération de polissage est de 1 % ou plus de l'intensité de la lumière émise.

13. Appareil de polissage selon la Revendication 11 ou la Revendication 12, **caractérisé en ce que** la plaque de fenêtre respective (31, 31a-31c) est constituée d'une résine possédant des caractéristiques de polissage comparables aux caractéristiques de polissage du corps de polissage susmentionné (21).

14. Procédé de mesure de l'épaisseur d'un film poli ou du point limite de polissage dans lequel le polissage est effectué à l'aide de l'appareil de polissage selon l'une quelconque des Revendications 11 à 13, et où l'épaisseur du film poli ou du point limite de polissage est mesurée par un signal lumineux reçu par un dispositif récepteur de lumière ; dans lequel le signal mesuré par les moyens de mesure utilisés pour mesurer l'épaisseur du film poli ou le point limite de polissage n'est pas utilisé pour la mesure de l'épaisseur du film poli ou du point limite de polissage dans les cas où le signal mesuré par les moyens de mesure susmentionnés est égal à un signal préalablement mesuré et mis en mémoire.

# FIG. 1 (a)

(b)

# FIG. 2

# FIG. 3

# FIG. 4

(a)

(b)

Section along line A-O

(c)

Section along line B-O

(d)

Section along line C-O

# FIG. 5

(a)

21

D      E

32

(b)

32

33a   33b   31   33c

Section along line D-E

21

# FIG. 6

(a)

F ____ G

21

32

(b)

32 34a 34b 34c 34d 21

31

Section along line F-G

# FIG. 7

(a)

H    I

21

32

(b)

31

35a  35b  35c 35d    32    21

Section along line H-I

# FIG. 8

(a)

A ——·—— B

21

32

31

32        36        21

(b)        Section along line A-B

37a        37

# FIG. 9

# FIG. 10

FIG. 11

FIG. 12

# FIG. 13

# FIG. 14

FIG. 15 (a) [41] [42]  (f) [46] [47]

(b) [43]  (g) [43]

(c) [44]  (h) [44]

(d) [49] [48]  (i) [50]

(e) } [45]  (j)

(k) [45] [46]

**FIG. 16**

# FIG. 17

# FIG. 18

(a)

Rotational trigger signal

PC

(b)

**FIG. 19**

**FIG. 20**

**EP 1 176 630 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5433651 A